# EUROPEAN PATENT APPLICATION

(11) **EP 4 531 528 A1**
(43) Date of publication of application: **02.04.2025**
(21) Application number: 24189437.7
(22) Date of filing: 18.07.2024
(51) Int. Cl.: H10K 59/40, H10K 50/844, H10K 59/80, H10K 50/85

(54) **DISPLAY DEVICE AND METHOD FOR MANUFACTURING THE DISPLAY DEVICE**

(30) Priority: 26.09.2023 KR 20230129845
(71) Applicant: Samsung Display Co., Ltd., Gyeonggi-do 17113 (KR)
(72) Inventor: JUNG, Yang Ho, 17113 Yongin-si (KR); KIM, Young Jun, 17113 Yongin-si (KR); SEO, Dong Kyun, 17113 Yongin-si (KR); SHIN, Hee Kyun, 17113 Yongin-si (KR); SIM, Jun Ho, 17113 Yongin-si (KR)
(74) Representative: Walaski, Jan Filip

(57) **Abstract**

Provided is display device and method for manufacturing the display device. A display device includes a substrate, a light emitting element layer disposed on the substrate, including a plurality of light emitting elements configured to emit light, a light control layer disposed on the light emitting element layer, including a light-transmitting layer configured to transmit the light, and a light-blocking layer configured to block the light. The display device further includes an intermediate layer including at least one of a thin film encapsulation layer or a touch sensor layer, wherein the intermediate layer is disposed between the light emitting element layer and the light control layer, and a groove passing through at least a portion of the intermediate layer, wherein at least a portion of the light-blocking layer is disposed in the groove.

## Description

This application claims priority to Korean Patent Application No. 10-2023-0129845, filed on September 26, 2023.

### BACKGROUND

### Technical Field

The present disclosure relates to a display device and a method for manufacturing the display device.

### Description of the Related Art

With the advancement of the information age, the demand for various forms of a display device for displaying an image has increased. A display device may be a flat panel display device such as, for example, a liquid crystal display device, a field emission display device, and a light emitting display device. The light emitting display device may include an organic light emitting display device that includes an organic light emitting diode element as a light emitting element or a light emitting diode display device that includes an inorganic light emitting diode element such as, for example, a light emitting diode (LED) as a light emitting element.

In the case of a display device for a vehicle, if the display device is placed in front of a driver or passenger and an image is displayed on the display device, reflection of the image on a windshield at night may interfere with the ability of the driver to effectively operate the vehicle. Accordingly, for example, approaches for controlling a viewing angle of an image displayed on a display device for a vehicle are desired. In some aspects, for privacy protection, approaches are desired for controlling the viewing angle of the image displayed on the display device for a vehicle such that the image displayed on the display device for the vehicle, which is placed in front of the driver, is not viewable by the passenger.

### SUMMARY

An object of the present disclosure provides a display device and a method for manufacturing the display device, in which viewing angle control characteristics are improved.

Another object of the present disclosure provides a display device and a method for manufacturing the display device, in which reliability of a light control layer is improved.

The objects of the present disclosure are not limited to those mentioned above and additional objects of the present disclosure, which are not mentioned herein, will be clearly understood by those skilled in the art from the following description of the present disclosure.

According to an aspect of the present disclosure, there is provided a display device including, a substrate, a light emitting element layer disposed on the substrate, including a plurality of light emitting elements configured to emit light, a light control layer disposed on the light emitting element layer, including a light-transmitting layer configured to transmit the light and a light-blocking layer configured to block the light, a first layer including at least one of a thin film encapsulation layer or a touch sensor layer, wherein the first layer is disposed between the light emitting element layer and the light control layer, and a groove passing through at least a portion of the first layer, wherein the light-blocking layer is disposed on the groove.

In an embodiment, the light-blocking layer overlaps the groove.

In an embodiment, at least a portion of the light-blocking layer is disposed in the groove.

In an embodiment, a width of the groove is greater than a width of the light-blocking layer.

In an embodiment, at least a portion of the light-transmitting layer is disposed in the groove.

In an embodiment, the light-transmitting layer is disposed between a side of the groove and a side of the light-blocking layer in the groove.

In an embodiment, the side of the groove and the side of the light-blocking layer may be in direct contact not in direct contact with each other in the groove.

In an embodiment, the touch sensor layer includes at least one touch electrode, and the groove does not overlap the touch electrode.

In an embodiment, a width of the groove is equal to a width of the light-blocking layer.

In an embodiment, a side of the groove and a side of the light-blocking layer may be in direct contact with each other in the groove.

In an embodiment, the light-transmitting layer is not disposed in the groove.

In an embodiment, the display device may further comprise a capping layer disposed between the groove and the light control layer.

In an embodiment, the capping layer covers a side and a bottom surface of the groove.

In an embodiment, the display device may further comprise an overcoat layer disposed on the light control layer.

In an embodiment, a bottom surface of the groove overlaps the thin film encapsulation layer.

In an embodiment, a bottom surface of the groove overlaps the touch sensor layer.

According to an aspect of the present disclosure, there is provided a method for manufacturing a display device, the method including, preparing a display panel, the display panel includes a substrate, a light emitting element layer disposed on the substrate, including a plurality of light emitting elements configured to emit light, and a first layer disposed on the light emitting element layer, including at least one of a thin film encapsulation layer or a touch sensor layer, forming a groove passing through at least a portion of the first layer, forming a light-transmitting layer on the groove, and forming a light-blocking layer between the light-transmitting layer and another light-transmitting layer, wherein the light-blocking layer is disposed on the groove.

In an embodiment, a width of the groove is greater than a width of the light-blocking layer.

According to an aspect of the present disclosure, there is provided a method for manufacturing a display device, the method including, preparing a display panel, the display panel includes a substrate, a light emitting element layer disposed on the substrate, the light emitting layer including a plurality of light emitting elements configured to emit light, and a first layer disposed on the light emitting element layer, the first layer including at least one of a thin film encapsulation layer or a touch sensor layer, forming a light-transmitting material layer on the first layer, forming a light-transmitting layer by forming a groove passing through at least a portion of the first layer and the light-transmitting material layer, and forming a light-blocking layer between the light-transmitting layer and another light-transmitting layer, wherein the light-blocking layer is disposed in the groove.

In an embodiment, a width of the groove is equal to a width of the light-blocking layer.

In the display device and the method for manufacturing the display device according to an embodiment, viewing angle control characteristics may be improved.

In the display device and the method for manufacturing the display device according to an embodiment, reliability of a light control layer may be improved.

The effects according to the embodiments of the present disclosure are not limited to those mentioned above and more various effects are included in the following description of the present disclosure.

### BRIEF DESCRIPTION OF THE DRAWINGS

The above and other aspects and features of the present disclosure will become more apparent by describing in detail embodiments thereof with reference to the attached drawings, in which:
FIG. 1 is an exploded perspective view illustrating a display device according to an embodiment;
FIG. 2 is a plan view illustrating a display device according to an embodiment;
FIG. 3 is an exploded perspective view illustrating a display device according to another embodiment;
FIG. 4 is a schematic cross-sectional view illustrating a display device, which is taken along line X1-X1' of FIG. 2;
FIG. 5 is a schematic view illustrating a display device applied to a vehicle;
FIG. 6 is a cross-sectional view illustrating an example of a display panel according to an embodiment;
FIG. 7a is a cross-sectional view illustrating a display panel and a light control layer according to an embodiment;
FIG. 7b is a cross-sectional view illustrating a display panel and a light control layer according to another embodiment;
FIG. 8 is an enlarged view illustrating an area A of FIG. 7a;
FIG. 9 is a cross-sectional view illustrating a display panel and a light control layer in a normal mode area and a privacy mode area of a display device according to an embodiment;
FIG. 10 is a cross-sectional view illustrating a display panel and a light control layer of a display device according to another embodiment;
FIG. 11 is an enlarged view illustrating an area B of FIG. 10;
FIG. 12 is a cross-sectional view illustrating a display panel, a capping layer and a light control layer of a display device according to another embodiment;
FIG. 13 is a cross-sectional view illustrating a display panel, a light control layer and an overcoat layer of a display device according to a further embodiment;
FIG. 14 is a cross-sectional view illustrating a display panel and a light control layer of a display device according to another embodiment;
FIG. 15 is a flow chart illustrating a method for manufacturing a display device according to an embodiment;
FIG. 16 is a cross-sectional view illustrating step S110 of FIG. 15;
FIG. 17 is a cross-sectional view illustrating step S120 of FIG. 15;
FIG. 18 is a cross-sectional view illustrating step S130 of FIG. 15;
FIG. 19 is a cross-sectional view illustrating step S140 of FIG. 15;
FIG. 20 is a cross-sectional view illustrating step S150 of FIG. 15;
FIG. 21 is a cross-sectional view illustrating step S160 of FIG. 15;
FIG. 22 is a flow chart illustrating a method for manufacturing a display device according to an embodiment;
FIG. 23 is a cross-sectional view illustrating step S210 of FIG. 22;
FIG. 24 is a cross-sectional view illustrating step S220 of FIG. 22;
FIG. 25 is a cross-sectional view illustrating step S230 of FIG. 22;
FIG. 26 is a cross-sectional view illustrating step S240 of FIG. 22; and
FIG. 27 is a cross-sectional view illustrating step S250 of FIG. 22.

### DETAILED DESCRIPTION OF THE DISCLOSURE

The invention will now be described more fully hereinafter with reference to the accompanying drawings, in which one or more example embodiments are illustrated. Aspects supported by the present disclosure may, however, be embodied in different forms and should not be construed as limited to the embodiments set forth herein. Rather, the example embodiments are provided such that this disclosure will be thorough and complete, and will filly convey the scope of example aspects of the present disclosure to those skilled in the art.

It will also be understood that when a layer is referred to as being "on" another layer or substrate, the layer can be directly on the other layer or substrate, or intervening layers may also be present. The same reference numbers indicate the same components throughout the specification.

Hereinafter, embodiments of the present disclosure will be described in detail with reference to the accompanying drawings.

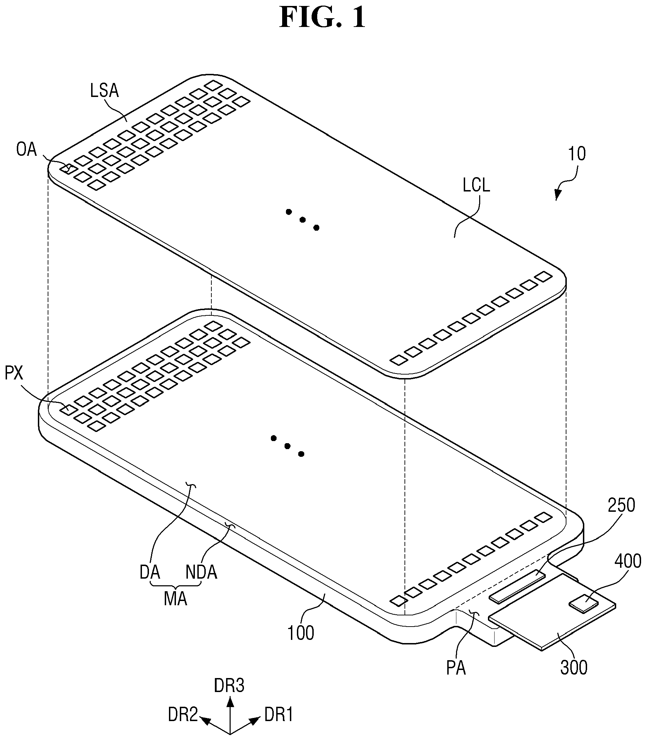

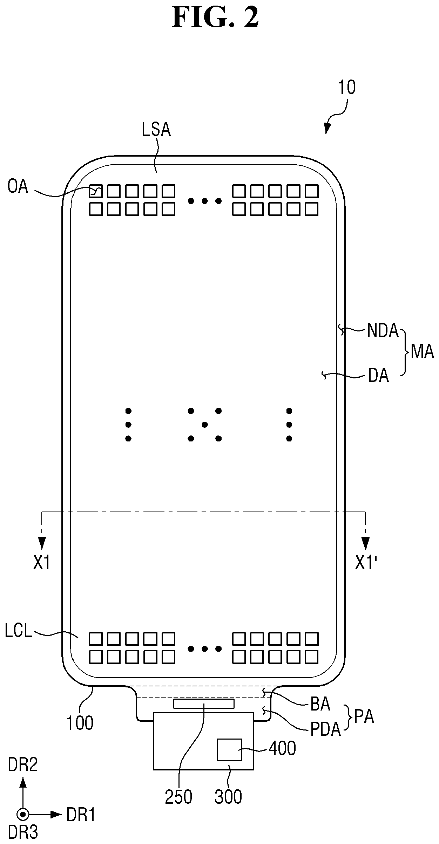

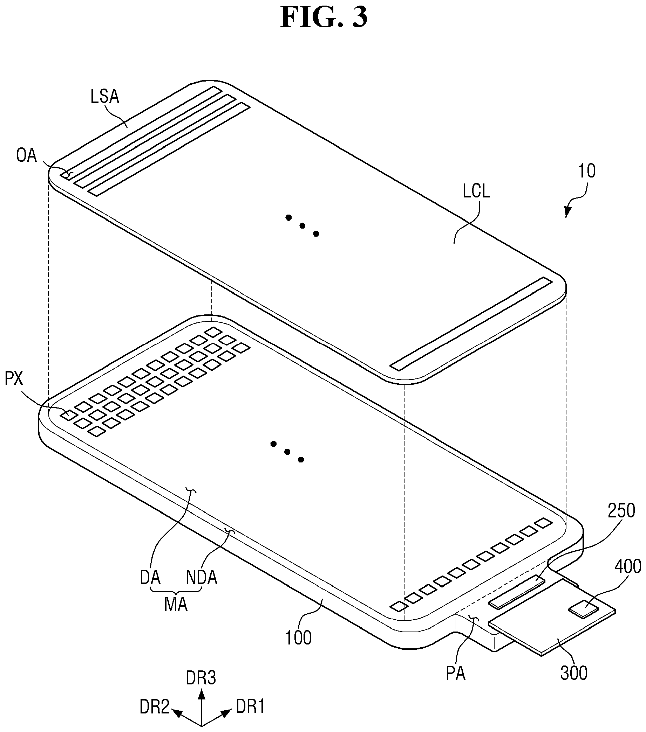

FIG. 1 is an exploded perspective view illustrating a display device according to an embodiment. FIG. 2 is a plan view illustrating a display device according to an embodiment. FIG. 3 is an exploded perspective view illustrating a display device according to another embodiment.

Referring to FIGS. 1 to 3, a display device 10 is a device that displays a moving image or a still image, and the display device 10 may be used as a display screen of various products such as, for example, a television, a laptop computer, a monitor, an advertising board, and an Internet of things (IoT) device as well as portable electronic devices such as, for example, a mobile phone, a smart phone, a tablet personal computer (PC), a smart watch, a watch phone, a mobile communication terminal, an electronic diary, an electronic book, a portable multimedia player (PMP), a navigator and an ultra mobile PC (UMPC). The display device 10 may be any one of an organic light emitting display device, a liquid crystal display device, a plasma display device, a field emission display device, an electrophoresis display device, an electrowetting display device, a quantum dot light emitting display device and a micro LED display device. The following description will be based on an example in which the display device 10 is an organic light emitting display device, but embodiments are not limited thereto.

The display device 10 may include a display panel 100, a display driving circuit 250, a circuit board 300 and a touch driving circuit 400.

The display panel 100 may include a plurality of pixels PX arranged in a first direction DR1 and a second direction DR2. Each of the pixels PX may be of a planar shape such as, for example, a rectangular shape, a square shape or a rhombus shape. For example, as illustrated in the drawing, each of the pixels PX may have a square planar shape, but the shape is not limited thereto. Each of the pixels PX may be of various shapes such as, for example, a polygonal shape, a circular shape and an oval shape on a plane.

In the illustrated drawing, the first direction DR1 and the second direction DR2 are horizontal directions (i.e. directions in the plane of the display device) and cross each other. For example, the first direction DR1 and the second direction DR2 may be orthogonal to each other. A third direction DR3 crosses the first direction DR1 and the second direction DR2, and may be, for example, a vertical direction orthogonal to the first direction DR1 and the second direction DR2.

The display panel 100 may include a main area MA and a protrusion area PA protruding from one side of the main area MA.

The main area MA may be formed in a rectangular shaped plane having a short side (a relatively shorter side) in the first direction DR1 and a long side (a relatively longer side) in the second direction DR2 crossing the first direction DR1. A corner at which the short side in the first direction DR1 and the long side in the second direction DR2 meet may be rounded according to a predetermined curvature or formed at a right angle. The planar shape of the display device 10 is not limited to the rectangular shape and may be formed in another polygonal shape, a circular shape, or an oval shape. The main area MA may be formed to be flat, but is not limited thereto. The main area MA may include a curved portion formed at left and right ends of the main area MA. In this case, for example, the curved portion may have a constant curvature or a variable curvature.

The main area MA includes a display area DA in which pixels are formed to display an image and a non-display area NDA that is a peripheral area of the display area DA.

Scan lines, data lines, and a power line, which are connected to the pixels, as well as the pixels may be disposed in the display area DA. In an example in which the main area MA includes a curved portion, the display area DA may be disposed in the curved portion. In this case, for example, an image of the display panel 100 may be viewed even in the curved portion.

The non-display area NDA may be defined as an area from the outside of the display area DA to an edge of the display panel 100. A scan driver for applying scan signals to the scan lines may be disposed in the non-display area NDA, and link lines for connecting the data lines with the display driving circuit 250 may be disposed in the non-display area NDA.

The protrusion area PA may be protruding from one side of the main area MA. For example, as illustrated in FIG. 2, the protrusion area PA may be protruding from a lower side of the main area MA. A length of the protrusion area PA in the first direction DR1 may be shorter than a length of the main area MA in the first direction DR1.

The protrusion area PA may include a bending area BA and a pad area PDA. In this case, for example, the pad area PDA may be disposed on one side of the bending area BA, and the main area MA may be disposed on the other side of the bending area BA. For example, the pad area PDA may be disposed below the bending area BA, and the main area MA may be disposed above the bending area BA.

The display panel 100 may be flexibly formed to be curved, bent, folded, or rolled. Therefore, the display panel 100 may be bent in a thickness direction, i.e., the third direction DR3 in the bending area BA. In this case, for example, one surface of the pad area PDA of the display panel 100 is directed upward before the display panel 100 is bent, and the same surface of the pad area PDA of the display panel 100 is directed downward after the display panel 100 is bent. As a result, the pad area PDA is disposed below the main area MA and thus may overlap the main area MA.

Pads electrically connected to the display driving circuit 250 and the circuit board 300 may be disposed in the pad area PDA of the display panel 100.

The display driving circuit 250 outputs signals and voltages for driving the display panel 100. For example, the display driving circuit 250 may supply data voltages to the data lines. In some aspects, the display driving circuit 250 may supply a power voltage to the power line and supply scan control signals to the scan driver. The display driving circuit 250 may be formed of an integrated circuit (IC), and the display driving circuit 250 may be mounted on the display panel 100 in the pad area PDA in a chip on glass (COG) mode, a chip on plastic (COP) mode, or an ultrasonic bonding mode, but is not limited thereto. For example, the display driving circuit 250 may be mounted on the circuit board 300.

The pads may include display pads electrically connected to the display driving circuit 250 and touch pads electrically connected to the touch lines.

The circuit board 300 may be attached onto the pads by using an anisotropic conductive film. Therefore, lead lines of the circuit board 300 may be electrically connected to the pads. The circuit board 300 may be a flexible printed circuit board, a printed circuit board, or a flexible film such as, for example, a chip on film.

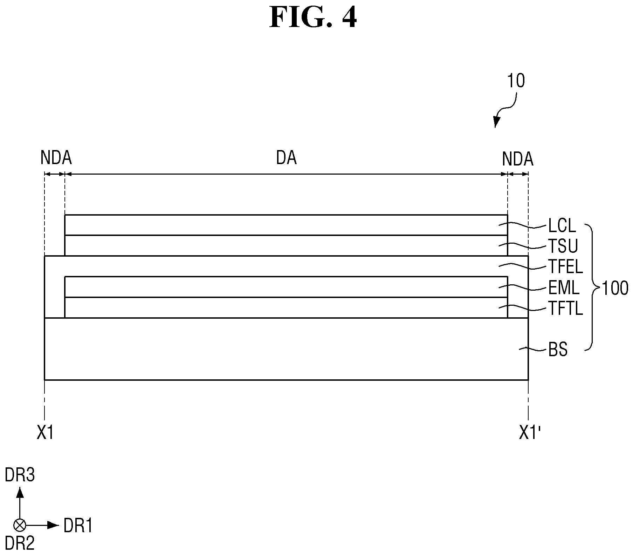

The touch driving circuit 400 may be connected to touch electrodes of a touch sensor layer TSU (see FIG. 4) of the display panel 100. The touch driving circuit 400 applies driving signals to the touch electrodes of the touch sensor layer TSU (see FIG. 4) and measures capacitance values of the touch electrodes. The driving signal may be a signal having a plurality of driving pulses. The touch driving circuit 400 may determine whether a touch input is received based on the capacitance values, and the touch driving circuit 400 may calculate touch coordinates at which the touch input is input.

The touch driving circuit 400 may be disposed on the circuit board 300. The touch driving circuit 400 may be formed of an integrated circuit (IC) and mounted on the circuit board 300.

In the display device 10 according to one or more embodiments, the display panel 100 includes a light control layer LCL.

The light control layer LCL may be directly disposed on the main area MA of the display panel 100. For example, the light control layer LCL may be embedded in the display panel 100 and disposed directly on the main area MA of the display panel 100. As the light control layer LCL is embedded in the display panel 100, a thickness and manufacturing cost of the display device 10 may be reduced as compared with a case in which a separate light control film is attached.

The light control layer LCL may be disposed on the display area DA of the main area MA. The light control layer LCL may adjust a viewing angle of light emitted from the display panel 100.

The size of the light control layer LCL may be greater than the size of the display area DA on a plane. In this case, for example, the light control layer LCL may overlap both the display area DA and the non-display area NDA.

The light control layer LCL may include transmissive areas OA arranged in the first direction DR1 and the second direction DR2 and a non-transmissive area LSA surrounding the transmissive areas OA.

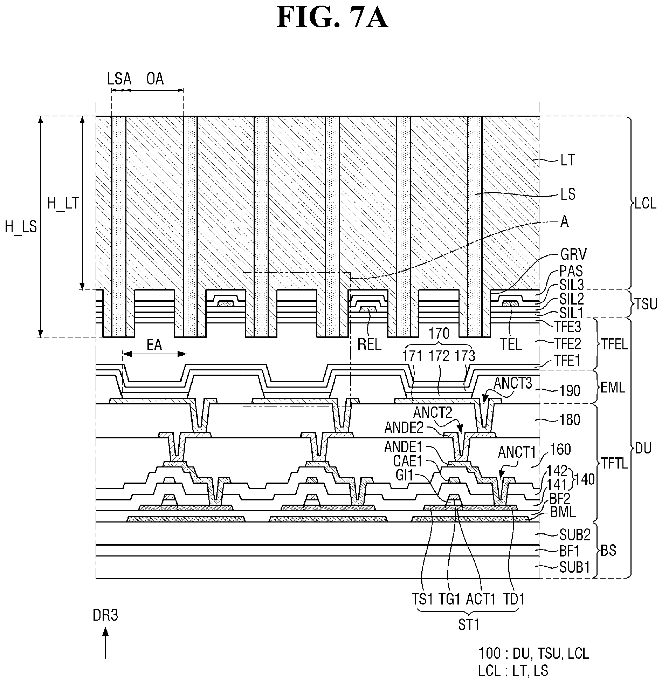

The transmissive areas OA may be areas in which a light-blocking layer LS (also referred to herein as a light-shielding layer LS) (see FIG. 7a) is not disposed. The transmissive areas OA may be areas through which light is transmitted and may extend along the third direction DR3.

Each of the transmissive areas OA may be of a rectangular shape on a plane as illustrated in FIGS. 1 and 2, but are not limited thereto. Each of the transmissive areas OA may be of a circular shape, an oval shape, or a polygonal shape on a plane.

In another example, the transmissive areas OA may be of a shape extending in the first direction DR1 or the second direction DR2. For example, as illustrated in FIG. 3, the transmissive areas OA may extend in the first direction DR1 and may be disposed along the second direction DR2. In another example, the transmissive areas OA may extend in the second direction DR2, and may be disposed along the first direction DR1.

As illustrated in FIG. 1, in an example in which the transmissive areas OA are disposed along the first direction DR1 and the second direction DR2, the viewing angle may be controlled in both the first direction DR1 and the second direction DR2. As illustrated in FIG. 3, in an example in which the transmissive areas OA are disposed along the first direction DR1 or the second direction DR2, the viewing angle may be controlled in the first direction DR1 or the second direction DR2. That is, various modifications may be made in the arrangement and shape of the transmissive areas OA based on a target control direction of the viewing angle (e.g., a target control direction associated with achieving the viewing angle).

The non-transmissive area LSA may be the remaining area of the light control layer LCL different from the transmissive area OA. The non-transmissive area LSA may be an area in which the light-blocking layer LS (see FIG. 7a) is disposed.

In the drawing, the non-transmissive area LSA is illustrated as being disposed to surround the transmissive area OA, but is not limited thereto. In some examples, the non-transmissive area LSA may extend in the same direction as the transmissive area OA and may be disposed to be alternate with the transmissive area OA. For example, as illustrated in FIG. 3, in an example in which the transmissive area OA extends in the first direction DR1, the non-transmissive area LSA may extend in the first direction DR1 and may be disposed to alternate with the transmissive area OA in the second direction DR2. Expressed another way, instances of the non-transmissive area LSA and the transmissive area OA may be alternately disposed in a direction (e.g., second direction DR2).

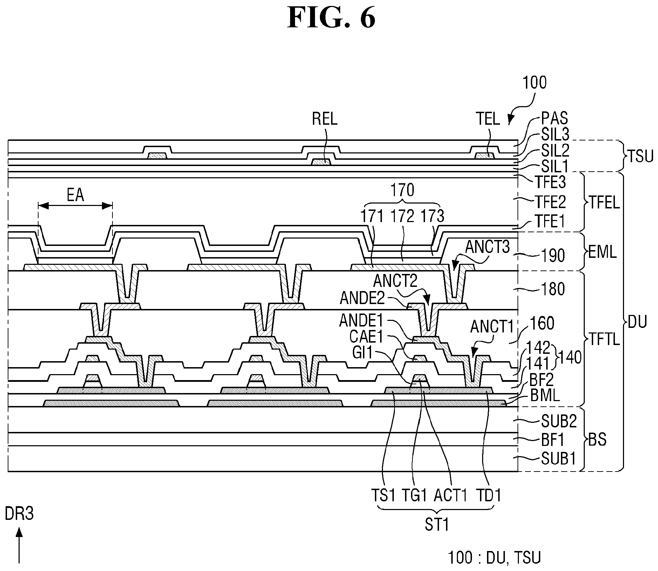

The light control layer LCL may include a light-blocking layer LS (see FIG. 7a) that blocks light emitted from a light emitting layer 172 (see FIG. 6) of the display panel 100 and a light-transmitting layer LT (see FIG. 7a) that transmits the light. A detailed structure of the light control layer LCL will be described later with reference to FIG. 7a.

FIG. 4 is a schematic cross-sectional view illustrating a display device 10, taken along line X1-X1' of FIG. 2.

Referring to FIG. 4, the display device 10 may include a display panel 100 in which the light control layer LCL is embedded. The display panel 100 may include a base member BS, a thin film transistor layer TFTL, a light emitting element layer EML, a thin film encapsulation layer TFEL, a touch sensor layer TSU, and a light control layer LCL.

The base member BS may include a substrate. The substrate may be formed of an insulating material such as, for example, glass, quartz or a polymer resin. Examples of the polymer material include polyethersulfone (PES), polyacrylate (PA), polyarylate (PAR), polyetherimide (PEI), polyethylene naphthalate (PEN), polyethylene terephthalate (PET), polyphenylene sulfide (PPS), polyallylate, polyimide (PI), polycarbonate (PC), cellulose triacetate (CAT), cellulose acetate propionate (CAP) or their combination. Alternatively, or additionally, the substrate may include a metal material.

The substrate may be a rigid substrate, or may be a flexible substrate capable of being subjected to bending, folding, rolling or the like. In an example in which the substrate is a flexible substrate, the substrate may be formed of polyimide (PI), but is not limited thereto.

The thin film transistor layer TFTL may be disposed on the base member BS. Scan lines, data lines, power lines, scan control lines, routing lines connecting the pads with the data lines, other connection components, and thin film transistors of the respective pixels may be formed in the thin film transistor layer TFTL. Each of the thin film transistors may include a gate electrode, a semiconductor layer, a source electrode, and a drain electrode.

The thin film transistor layer TFTL may be disposed in the display area DA and the non-display area NDA. In detail, the thin film transistors of the respective pixels, the scan lines, the data lines, and the power lines of the thin film transistor layer TFTL may be disposed in the display area DA. The scan control lines and lines of the thin film transistor layer TFTL may be disposed in the non-display area NDA.

The light emitting element layer EML may be disposed on the thin film transistor layer TFTL. The light emitting element layer EML may include pixels, which include a first electrode, a light emitting layer, and a second electrode, and a pixel defining layer for defining the pixels. The light emitting layer may be an organic light emitting layer that includes an organic material. In this case, for example, the light emitting layer may include a hole transporting layer, an organic light emitting layer, and an electron transporting layer. In an example in which a predetermined voltage is applied to the first electrode through the thin film transistor of the thin film transistor layer TFTL and a cathode voltage is applied to the second electrode, holes and electrons move to the organic light emitting layer through the hole transporting layer and the electron transporting layer, respectively, and combine with each other in the organic light emitting layer to emit light. The pixels of the light emitting element layer EML may be disposed in the display area DA.

The thin film encapsulation layer TFEL may be disposed on the light emitting element layer EML. The thin film encapsulation layer TFEL may serve to prevent oxygen or moisture from permeating into the light emitting element layer EML. In some aspects, the thin film encapsulation layer TFEL may include at least one inorganic layer. The inorganic layer may be a silicon nitride layer, a silicon oxynitride layer, a silicon oxide layer, a titanium oxide layer, or an aluminum oxide layer, but is not limited thereto. In some aspects, the thin film encapsulation layer TFEL may serve to protect the light emitting element layer EML from particles such as, for example, dust. In some aspects, the thin film encapsulation layer TFEL may include at least one organic layer. The organic layer may be an acryl resin, an epoxy resin, a phenolic resin, a polyamide resin, or a polyimide resin, but is not limited thereto.

The thin film encapsulation layer TFEL may be disposed in both the display area DA and the non-display area NDA. In detail, the thin film encapsulation layer TFEL may be disposed to cover the light emitting element layer EML of the display area DA and the non-display area NDA and cover the thin film transistor layer TFTL of the non-display area NDA.

The touch sensor layer TSU may be disposed on the thin film encapsulation layer TFEL. In accordance with one or more embodiments of the present disclosure, as the touch sensor layer TSU is disposed directly on the thin film encapsulation layer TFEL, the thickness of the display device 10 may be reduced as compared with other devices in which a separate touch panel including the touch sensor layer TSU is attached onto the thin film encapsulation layer TFEL.

The touch sensor layer TSU may include touch electrodes for sensing a touch input of a user in a capacitance manner and touch lines for connecting the pads with the touch electrodes. For example, the touch sensor layer TSU may sense a touch input of a user in a self-capacitance manner or a mutual capacitance manner.

The touch electrodes of the touch sensor layer TSU may be disposed in a touch sensor area that overlaps the display area DA. The touch lines of the touch sensor layer TSU may be disposed in a touch peripheral area that overlaps the non-display area NDA.

The light control layer LCL may be disposed on the touch sensor layer TSU. The light control layer LCL may be disposed such that the light control layer LCL overlaps the display area DA. The light control layer LCL may serve to absorb or block light moving out of a predetermined angle with respect to the third direction DR3 among the light emitted from the light emitting element layer EML. That is, the light control layer LCL may control the viewing angle.

Although not illustrated, the display device 10 may further include a cover window. The cover window may be additionally disposed on the light control layer LCL. In this case, for example, the light control layer LCL and the cover window may be attached to each other by a transparent adhesive member such as, for example, an optically clear adhesive (OCA) film.

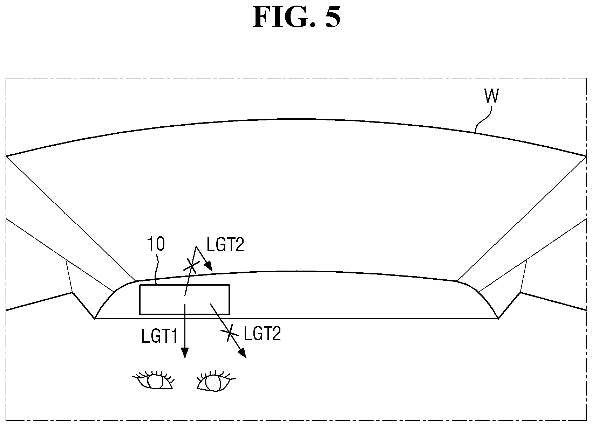

FIG. 5 is a schematic view illustrating a display device applied to a vehicle.

Referring to FIG. 5, the display device 10 according to an embodiment may be, for example, a display device applied to a vehicle. The vehicle may include a vehicle body constituting an external appearance of the vehicle and an interior space defined by the vehicle body. The vehicle body may include a windshield W that protects a driver and a passenger from the outside and provides a field of view to the driver. As illustrated in FIG. 5, the display device 10 may be provided in the interior space.

The display device 10 may be disposed on a dashboard provided in the interior space. For example, the display device 10 may be disposed on the dashboard in front of the driver's seat and be configured to provide speed information and other vehicle information to the driver, may be disposed on the dashboard in front of the passenger's seat and configured to provide entertainment information and the like to the passenger, or may be disposed at the center of the dashboard and configured to provide map information and the like. FIG. 5 illustrates an example of the display device 10 disposed on the dashboard in front of the driver's seat and a driver who views a display screen of the display device 10. The vehicle may include multiple display devices 10 (not illustrated).

The driver may recognize (or view) the display screen of the display device 10 through light LGT1 emitted from the display device 10 toward the driver. However, some light LGT2 of the light emitted from the display device 10 may be reflected toward the surrounding windshield W and then provided to the driver. In this case, for example, an image reflected on the windshield W may interfere with driving of the driver. In the case of the display device 10 according to an embodiment, aspects of the display device 10 support adjusting a front viewing angle (the angle at which the driver facing the display device views the display screen), particularly a vertical (up and down) viewing angle, of the light LGT1 and LGT2 emitted from the display device 10, such that a portion of light LGT2 of the light emitted from the display device 10 is prevented from being transmitted toward the surrounding windshield W. Accordingly, for example, the display device 10 may prevent a portion of light LGT2 from being reflected toward the driver from the surrounding windshield W.

In some aspects, some light LGT2 of the light emitted from the display device 10 may be provided or emitted toward the passenger. In this case, for example, the display device 10 may be vulnerable to privacy protection. However, in the case of the display device 10 according to an embodiment, aspects of the display device 10 support adjusting the front viewing angle, particularly a horizontal (side to side) viewing angle, of the light LGT1 and LGT2 emitted from the display device 10, such that the light LGT1 and LGT2 emitted from the display device 10 is prevented from being emitted toward the passenger. That is, for example, with respect to the display device 10 disposed in front of the driver of a vehicle, aspects of the display device 10 support preventing the image displayed on the display device 10 from being provided to the passenger.

The viewing angle may be adjusted through the light control layer LCL. The viewing angle may be limited to a predetermined angle range through the light control layer LCL. In an example in which the driver faces the display device (e.g., the driver is horizontally in front of the display device 10) and a virtual line extending in a direction perpendicular to a display surface of the display device 10 is a normal line, the viewing angle may be an angle within 35° from the normal line. In some embodiments, an angle within 35° from the normal line may be defined as an effective viewing angle, but the angle is not limited thereto. The display device 10 described herein support any suitable viewing angle supportive of features (e.g., light blocking, reduced reflection or glare toward the driver, privacy protection, and the like) of the display device 10.

FIG. 6 is a cross-sectional view illustrating an example of a display panel according to an embodiment. In FIG. 6, for convenience of description, the light control layer LCL is omitted.

Referring to FIG. 6, the display panel 100 may include a display layer DU and a touch sensor layer TSU. The display layer DU may include a base member BS, a thin film transistor layer TFTL, a light emitting element layer EML, and a thin film encapsulation layer TFEL.

The base member BS may include a first substrate SUB1, a first buffer layer BF1 disposed on the first substrate SUB1, and a second substrate SUB2 disposed on the first buffer layer BF1.

The first substrate SUB1 and the second substrate SUB2 may be formed of an insulating material such as, for example, glass, quartz or a polymer resin. An example of the polymer material may include polyethersulfone (PES), polyacrylate (PA), polyarylate (PAR), polyetherimide (PEI), polyethylene naphthalate (PEN), polyethylene terephthalate (PET), polyphenylene sulfide (PPS), polyallylate, polyimide (PI), polycarbonate (PC), cellulose triacetate (CAT), cellulose acetate propionate (CAP) or their combination. Alternatively, or additionally, the substrate may include a metal material.

Each of the first substrate SUB1 and the second substrate SUB2 may be a rigid substrate. Additionally, or alternatively, one or more of the first substrate SUB1 and the second substrate SUB2 may be a flexible substrate capable of being subjected to bending, folding, rolling or the like. In an example in which a substrate (e.g., first substrate SUB1, second substrate SUB2) is a flexible substrate, the substrate may be formed of polyimide (PI), but is not limited thereto.

The first buffer layer BF1 may be a layer for protecting the first thin film transistor ST1 and the light emitting layer 172 from moisture permeated through the first substrate SUB1 and the second substrate SUB2, which are vulnerable to moisture permeation. The first buffer layer BF1 may include a plurality of inorganic layers that are alternately stacked. For example, the first buffer layer BF1 may be formed of a multi-layer in which one or more inorganic layers of a silicon nitride layer, a silicon oxynitride layer, a silicon oxide layer, a titanium oxide layer, and an aluminum oxide layer are alternately stacked.

The thin film transistor layer TFTL may include a lower metal layer BML, a second buffer layer BF2, a first thin film transistor ST1, a first gate insulating layer GI1, a first interlayer insulating layer 141, a first capacitor electrode CAE1, a second interlayer insulating layer 142, a first anode connection electrode ANDE1, a first organic layer 160, a second anode connection electrode ANDE2, and a second organic layer 180.

The lower metal layer BML may be disposed on the second substrate SUB2. The lower metal layer BML may be disposed such that the lower metal layer BML overlaps a first active layer ACT1 of the first thin film transistor ST1 in the third direction DR3 in order to prevent a leakage current from occurring when light is incident on the first active layer ACT1 of the first thin film transistor ST1. The lower metal layer BML may be formed of a single layer or multi-layer formed of one of molybdenum (Mo), aluminum (Al), chromium (Cr), gold (Au), titanium (Ti), nickel (Ni), neodymium (Nd) and copper (Cu), or an alloy thereof. The lower metal layer BML may be omitted.

The second buffer layer BF2 may be disposed on the lower metal layer BML. The second buffer layer BF2 is a layer for protecting the first thin film transistor ST1 and the light emitting layer 172 from moisture permeated through the first substrate SUB1 and the second substrate SUB2, which are vulnerable to moisture permeation. The second buffer layer BF2 may include a plurality of inorganic layers that are alternately stacked. For example, the second buffer layer BF2 may be formed of a multi-layer in which one or more inorganic layers of a silicon nitride layer, a silicon oxynitride layer, a silicon oxide layer, a titanium oxide layer and an aluminum oxide layer are alternately stacked.

The first active layer ACT1 of the first thin film transistor ST1 may be disposed on the second buffer layer BF2. The first active layer ACT1 of the first thin film transistor ST1 includes polycrystalline silicon, monocrystalline silicon, low temperature polycrystalline silicon, amorphous silicon, or an oxide semiconductor. Since the first active layer ACT1 of the first thin film transistor ST1 exposed without being covered by the first gate insulating layer GI1 is doped with impurities or ions, the first active layer ACT1 of the first thin film transistor ST1 may have conductivity. Therefore, a first source electrode TS1 and a first drain electrode TD1 of the first active layer ACT1 of the first thin film transistor ST1 may be formed.

The first gate insulating layer GI1 may be disposed on the first active layer ACT1 of the first thin film transistor ST1. In FIG. 5, the first gate insulating layer GI1 is illustrated as being disposed between the first gate electrode TG1 and the first active layer ACT1 of the first thin film transistor ST1, but is not limited thereto. The first gate insulating layer GI1 may be disposed between the first interlayer insulating layer 141 and the first active layer ACT1 and between the first interlayer insulating layer 141 and the second buffer layer BF2. The first gate insulating layer GI1 may be formed of an inorganic layer, for example, a silicon nitride layer, a silicon oxynitride layer, a silicon oxide layer, a titanium oxide layer, or an aluminum oxide layer.

The first gate electrode TG1 of the first thin film transistor ST1 may be disposed on the first gate insulating layer GI1. The first gate electrode TG1 of the first thin film transistor ST1 may overlap the first active layer ACT1 in the third direction DR3. The first gate electrode TG1 of the first thin film transistor ST1 may be formed of a single layer or multi-layer formed of any one of molybdenum (Mo), aluminum (Al), chromium (Cr), gold (Au), titanium (Ti), nickel (Ni), neodymium (Nd) and copper (Cu), or an alloy thereof.

The first interlayer insulating layer 141 may be disposed on the first gate electrode TG1 of the first thin film transistor ST1. The first interlayer insulating layer 141 may be formed of an inorganic layer, for example, a silicon nitride layer, a silicon oxynitride layer, a silicon oxide layer, a titanium oxide layer, or an aluminum oxide layer. The first interlayer insulating layer 141 may include a plurality of inorganic layers.

The first capacitor electrode CAE1 may be disposed on the first interlayer insulating layer 141. The first capacitor electrode CAE1 may overlap the first gate electrode TG1 of the first thin film transistor ST1 in the third direction (Z-axis direction). The first interlayer insulating layer 141 has a predetermined dielectric constant, and a capacitor may be formed by the first capacitor electrode CAE1, the first gate electrode TG1, and the first interlayer insulating layer 141 disposed between the first capacitor electrode CAE1 and the first gate electrode TG1. The first capacitor electrode CAE1 may be formed of a single layer or multi-layer formed of any one of molybdenum (Mo), aluminum (Al), chromium (Cr), gold (Au), titanium (Ti), nickel (Ni), neodymium (Nd) and copper (Cu), or an alloy thereof.

The second interlayer insulating layer 142 may be disposed on the first capacitor electrode CAE1. The second interlayer insulating layer 142 may be formed of an inorganic layer, for example, a silicon nitride layer, a silicon oxynitride layer, a silicon oxide layer, a titanium oxide layer, or an aluminum oxide layer. The second interlayer insulating layer 142 may include a plurality of inorganic layers.

The first anode connection electrode ANDE1 may be disposed on the second interlayer insulating layer 142. The first anode connection electrode ANDE1 may be connected to the first drain electrode TD1 of the first thin film transistor ST1 through a first anode contact hole ANCT1, which exposes the first drain electrode TD1 of the first thin film transistor ST1, by passing through the first interlayer insulating layer 141 and the second interlayer insulating layer 142. The first anode connection electrode ANDE1 may be formed of a single layer or multi-layer formed of any one of molybdenum (Mo), aluminum (Al), chromium (Cr), gold (Au), titanium (Ti), nickel (Ni), neodymium (Nd) and copper (Cu), or an alloy thereof.

The first organic layer 160 for planarization may be disposed on the first anode connection electrode ANDE1. The first organic layer 160 may be formed of an organic layer such as, for example, acryl resin, epoxy resin, phenolic resin, polyamide resin, and polyimide resin.

The second anode connection electrode ANDE2 may be disposed on the first organic layer 160. The second anode connection electrode ANDE2 may be connected to the second anode connection electrode ANDE2 through a second anode contact hole ANT2, which exposes the first anode connection electrode ANDE1, by passing through the first organic layer 160. The second anode connection electrode ANDE2 may be formed of a single layer or multi-layer formed of any one of molybdenum (Mo), aluminum (Al), chromium (Cr), gold (Au), titanium (Ti), nickel (Ni), neodymium (Nd), and copper (Cu), or an alloy thereof.

The second organic layer 180 may be disposed on the second anode connection electrode ANDE2. The second organic layer 180 may be formed of an organic layer such as, for example, acryl resin, epoxy resin, phenolic resin, polyamide resin, and polyimide resin.

In FIG. 6, the first thin film transistor ST1 is formed in a top gate mode in which the first gate electrode TG1 is positioned above the first active layer ACT1, but is not limited thereto. The first thin film transistor ST1 may be formed in a bottom gate mode in which the first gate electrode TG1 is disposed below the first active layer ACT1 or a double gate mode in which the first gate electrode TG1 is disposed above and below the first active layer ACT1.

The light emitting element layer EML may be disposed on the second organic layer 180. The light emitting element layer EML may include light emitting elements 170 and a bank 190. Each of the light emitting elements 170 may include a first light emitting electrode 171, a light emitting layer 172 and a second light emitting electrode 173.

The first light emitting electrode 171 may be formed on the second organic layer 180. The first light emitting electrode 171 may be connected to the second anode connection electrode ANDE2 through a third anode contact hole ANCT3, which exposes the second anode connection electrode ANDE2, by passing through the second organic layer 180.

The first light emitting electrode 171 may be formed on the second organic layer 180. The first light emitting electrode 171 may be connected to the second anode connection electrode ANDE2 through a third anode contact hole ANT3, which exposes the second anode connection electrode ANDE2, by passing through the second organic layer 180.

In a top emission structure in which light is emitted toward the second light emitting electrode 173 based on the light emitting layer 172, the first light emitting electrode 171 may be formed of a metal material having high reflectivity, such as, for example, a stacked structure (Ti/AI/Ti) of aluminum and titanium, a stacked structure (ITO/AI/ITO) of aluminum and ITO, an APC alloy, and a stacked structure (ITO/APC/ITO) of the APC alloy and ITO. The APC alloy is an alloy of silver (Ag), palladium (Pd), and copper (Cu).

The bank 190 may be formed to partition the first light emitting electrode 171 on the second organic layer 180 in order to serve to define a light emission area EA. The bank 190 may be formed to cover an edge of the first light emitting electrode 171. The bank 190 may be formed of an organic layer such as, for example, acryl resin, epoxy resin, phenolic resin, polyamide resin, and polyimide resin.

The light emission area EA refers to an area in which the first light emitting electrode 171, the light emitting layer 172 and the second light emitting electrode 173 are sequentially stacked such that holes from the first light emitting electrode 171 and electrons from the second light emitting electrode 173 are combined with each other in the light emitting layer 172 to emit light.

The light emitting layer 172 is formed on the first light emitting electrode 171 and the bank 190. The light emitting layer 172 may include an organic material and be configured to emit light of a predetermined color. For example, the light emitting layer 172 may include a hole transporting layer, an organic material layer, and an electron transporting layer.

The second light emitting electrode 173 may be disposed on the light emitting layer 172. The second light emitting electrode 173 may be formed such that the electrode 173 covers the light emitting layer 172. The second light emitting electrode 173 may be a common layer commonly formed in all of the light emission areas EA. In some embodiments, although not illustrated, a capping layer may be formed on the second light emitting electrode 173.

In the top emission structure, the second light emitting electrode 173 may be formed of a transparent conductive oxide (TCO) such as, for example, indium tin oxide (ITO) and indium zinc oxide (IZO) or a semi-transmissive conductive material such as, for example, magnesium (Mg), silver (Ag), or an alloy of magnesium (Mg) and silver (Ag). In an example in which the second light emitting electrode 173 is formed of a semi-transmissive conductive material, light emission efficiency may be enhanced by a micro cavity.

The thin film encapsulation layer TFEL may be disposed on the second light emitting electrode 173. The thin film encapsulation layer TFEL may include at least one inorganic layer to prevent oxygen or moisture from permeating into the light emitting element layer. The thin film encapsulation layer TFEL may also include at least one organic layer to protect the light emitting element layer from particles such as, for example, dust. For example, the thin film encapsulation layer TFEL may include a first encapsulation layer TFE1, a second encapsulation layer TFE2, and a third encapsulation layer TFE3.

The first encapsulation layer TFE1 (e.g., the first inorganic encapsulation layer) may be disposed on the second light emitting electrode 173. The first encapsulation layer TFE1 may be an inorganic layer of a single layer or multi-layer. The first encapsulation layer TFE1 may be formed of a multi-layer or single layer, in which one or more inorganic layers of a silicon nitride layer, a silicon oxynitride layer, a silicon oxide layer, a titanium oxide layer, and an aluminum oxide layer are alternately stacked.

The second encapsulation layer TFE2 (e.g., the first organic encapsulation layer) may be disposed on the first encapsulation layer TFE1. The second encapsulation layer TFE2 may be an organic layer of a single layer or multi-layer. The second encapsulation layer TFE2 may include a polymer-based material. The polymer-based material may include polyethylene terephthalate, polyethylene naphthalate, polycarbonate, polyimide, polyethylene sulfonate, polyoxymethylene, polyarylate, hexamethyldisiloxane, acrylic resin (e.g., polymethyl methacrylate, polyacrylic acid, or the like) or any combination thereof.

The third encapsulation layer TFE3 (e.g., the second inorganic encapsulation layer) may be disposed on the second encapsulation layer TFE2. The third encapsulation layer TFE3 may be an inorganic layer of a single layer or multi-layer. The material included in the third encapsulation layer TFE3 may be the same as the material included in the first encapsulation layer TFE1. For example, the third encapsulation layer TFE3 may be formed of a multi-layer or single layer, in which one or more inorganic layers of a silicon nitride layer, a silicon oxynitride layer, a silicon oxide layer, a titanium oxide layer, and an aluminum oxide layer are alternately stacked.

The touch sensor layer TSU may be disposed on the thin film encapsulation layer TFEL. The touch sensor layer TSU may include a plurality of touch electrodes for sensing a touch input of a user in a capacitance manner and touch lines for connecting the plurality of touch electrodes with the touch driving circuit. For example, the touch sensor layer TSU may sense a touch input of a user in a mutual capacitance manner or a self-capacitance manner.

In another implementation, the touch sensor layer TSU may be disposed on a separate substrate disposed on the display layer DU. In this case, for example, the substrate for supporting the touch sensor layer TSU may be an encapsulation member for encapsulating the display layer DU.

The plurality of touch electrodes of the touch sensor layer TSU may be disposed in the touch sensor area that overlaps the display area. The touch lines of the touch sensor layer TSU may be disposed in the touch peripheral area that overlaps the non-display area.

The touch sensor layer TSU may include a first touch insulating layer SIL1, a first touch electrode REL, a second touch insulating layer SIL2, a second touch electrode TEL, and a third touch insulating layer SIL3.

The first touch insulating layer SIL1 may be disposed on the thin film encapsulation layer TFEL. The first touch insulating layer SIL1 may have insulating and optical functions. The first touch insulating layer SIL1 may include at least one inorganic layer. For example, the first touch insulating layer SIL1 may be an inorganic layer that includes at least one of a silicon nitride layer, a silicon oxynitride layer, a silicon oxide layer, a titanium oxide layer, or an aluminum oxide layer. Optionally, the first touch insulating layer SIL1 may be omitted.

The first touch electrode REL may be disposed on the first touch insulating layer SIL1. In some embodiments, the first touch electrode REL may not overlap the light emitting element 170. The first touch electrode REL may be formed of a single layer of molybdenum (Mo), titanium (Ti), copper (Cu), aluminum (Al), or indium tin oxide (ITO), or may be formed of a stacked structure (Ti/AI/Ti) of aluminum and titanium, a stacked structure (ITO/AI/ITO) of aluminum and ITO, an APC alloy, or a stacked structure (ITO/APC/ITO) of the APC alloy and ITO.

The second touch insulating layer SIL2 may cover the first touch electrode REL and the first touch insulating layer SIL1. The second touch insulating layer SIL2 may have insulating and optical functions. For example, the second touch insulating layer SIL2 may be formed of the material exemplified as the first touch insulating layer SIL1.

The second touch electrode TEL may be disposed on the second touch insulating layer SIL2. In some embodiments, the second touch electrode TEL may not overlap the light emitting element 170. The second touch electrode TEL may be formed of a single layer of molybdenum (Mo), titanium (Ti), copper (Cu), aluminum (Al), or indium tin oxide (ITO), or may be formed of a stacked structure (Ti/AI/Ti) of aluminum and titanium, a stacked structure (ITO/AI/ITO) of aluminum and ITO, an APC alloy, or a stacked structure (ITO/APC/ITO) of the APC alloy and ITO.

The third touch insulating layer SIL3 may cover the second touch electrode TEL and the second touch insulating layer SIL2. The third touch insulating layer SIL3 may have insulating and optical functions. The third touch insulating layer SIL3 may be formed of the material exemplified as the second touch insulating layer SIL2.

The first touch insulating layer SIL1, the second touch insulating layer SIL2, and the third touch insulating layer SIL3 may be organic layers. For example, the first touch insulating layer SIL1, the second touch insulating layer SIL2, and the third touch insulating layer SIL3 may be organic layers such as, for example, acryl resin, epoxy resin, phenolic resin, polyamide resin, and polyimide resin.

The touch sensor layer TSU may further include a planarization layer PAS for planarization. The planarization layer PAS may be formed of an organic layer such as, for example, acryl resin, epoxy resin, phenolic resin, polyamide resin, and polyimide resin.

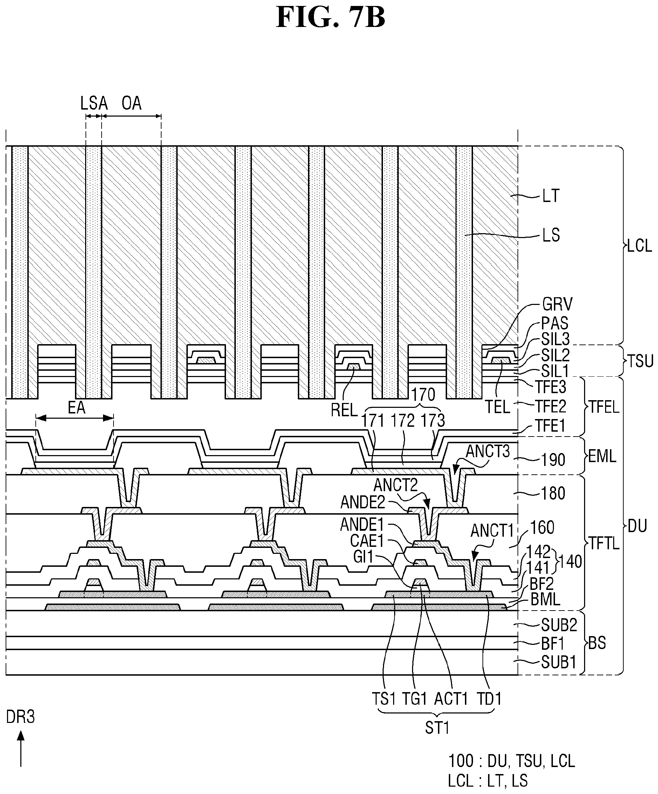

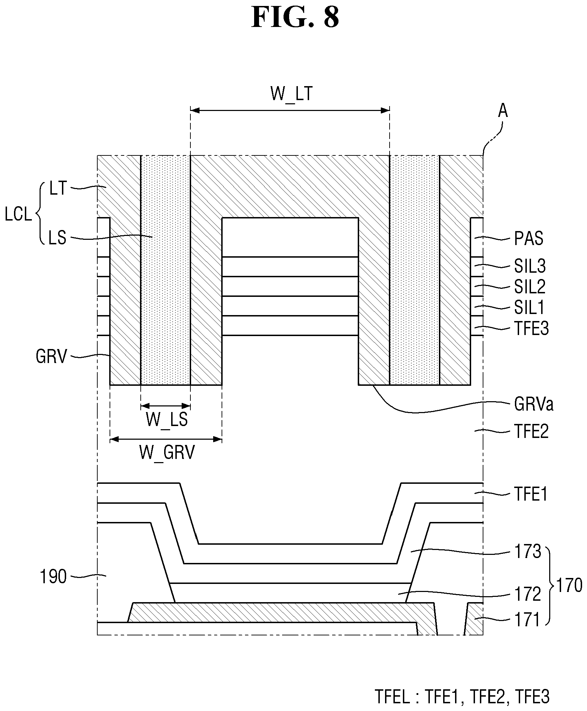

FIG. 7a is a cross-sectional view illustrating a display panel and a light control layer according to an embodiment. FIG. 7b is a cross-sectional view illustrating a display panel and a light control layer according to another embodiment. FIG. 8 is an enlarged view illustrating an area A of FIG. 7a.

Referring to FIGS. 7a and 7b and FIG. 8 in addition to FIGS. 1 to 3, the light control layer LCL may be disposed on the touch sensor layer TSU. The light control layer LCL may control the viewing angle of the light emitted from the light emitting layer 172. In an example in which the light emitted from the light emitting layer 172 proceeds according to a predetermined angle or less with respect to the third direction DR3, the light may be emitted to the outside. In an example in which the light emitted from the light emitting layer 172 proceeds according to an angle greater than the predetermined angle with respect to the third direction DR3, the light may be absorbed or blocked by the light-blocking layer LS and thus may not be emitted to the outside.

The light control layer LCL includes a light-transmitting layer LT and a light-blocking layer LS.

The light-blocking layer LS may be disposed in the non-transmissive area LSA. The light-blocking layer LS may be disposed to alternate with the light-transmitting layer LT in the first direction DR1 or the second direction DR2. In another implementation, the light-blocking layer LS may include a plurality of openings disposed in the transmissive area OA as illustrated in FIG. 1. In this case, for example, the light-blocking layer LS may surround the light-transmitting layer LT.

The light-blocking layer LS may absorb or block the light emitted from the light emitting layer 172. The light-blocking layer LS may include a light-blocking organic material. For example, the light-blocking layer LS is a photosensitive resin capable of absorbing or shielding light, and may include an organic material that includes an organic black pigment such as, for example, carbon black.

The light-transmitting layer LT may be disposed in the transmissive area OA. The light-transmitting layer LT may be disposed to alternate with the light-blocking layer LS in the first direction DR1 or the second direction DR2 as illustrated in FIG. 3. In another example, the light-transmitting layer LT may be disposed in the opening of the light-blocking layer LS as illustrated in FIG. 1, and may be surrounded by the light-blocking layer LS.

The light-transmitting layer LT may transmit the light emitted from the light emitting layer 172. The light-transmitting layer LT may include a transparent organic material. For example, the light-transmitting layer LT may include an organic layer such as, for example, an acryl resin, an epoxy resin, a phenolic resin, a polyamide resin, and a polyimide resin. The light-transmitting layer LT may include silicon oxynitride or silicon oxide.

The width W_LT of the light-transmitting layer LT may be greater than the width W_LS of the light-blocking layer LS. For example, the width W_LT of the light-transmitting layer LT may be 2 times to 5 times the width W_LS of the light-blocking layer LS. For example, the width W_LS of the light-blocking layer LS may be about 2 µm to about 10 µm, but is not limited thereto.

As illustrated in FIG. 7a, the light-blocking layer LS may be disposed in an area other than the light emission area EA. The light-blocking layer LS may be disposed only in an area other than the light emission area EA. In some other configurations, the light-blocking layer LS may be disposed such that the light-blocking layer LS partially overlaps the light emission area EA. For example, the light-blocking layer LS may overlap the bank 190 in the third direction DR3. In this case, for example, light having a low viewing angle (e.g., below a threshold value) among the light generated from the light emitting layer 172 is blocked relatively less compared to light having a relatively higher viewing angle, such that luminance of the display device 10 may be prevented from being reduced.

As illustrated in FIG. 7b, the light-blocking layer LS may be disposed in the light emission area EA and an area other than the light emission area EA. Although not illustrated in the drawings, the light-blocking layer LS may be disposed in the light emission area EA, without being disposed outside the light emission area EA. In an example in which the light-blocking layer LS is also disposed in the light emission area EA, viewing angle control characteristics of the light control layer LCL may be improved. Therefore, a total thickness of the light control layer LCL, that is, a thickness of the light control layer LC in the third direction DR3 may be reduced.

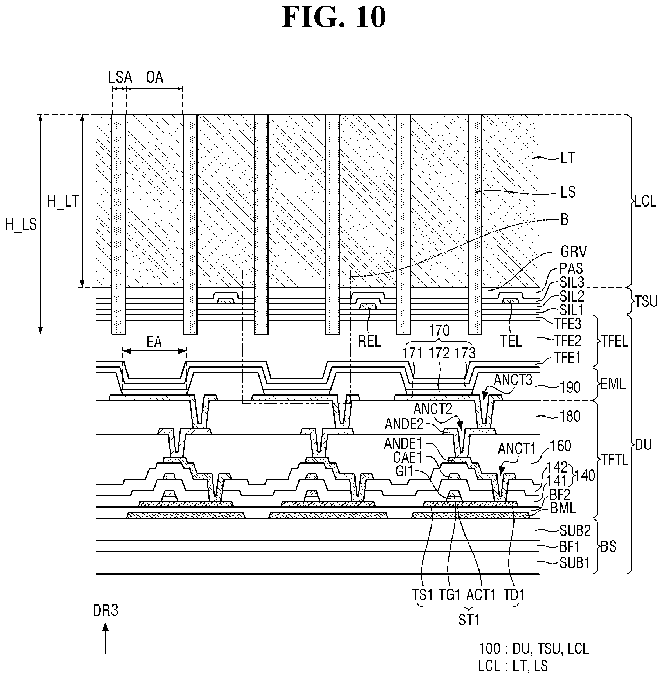

That is, according to viewing angle control characteristics and luminance characteristics of the display device 10, a position relation between the light-blocking layer LS and the light emission area EA may be formed in various ways. In the following embodiments described with reference to FIG. 10 and other figures provided herein, for convenience of description, the light-blocking layer LS is illustrated as being disposed in both the light emission area EA and an area other than the light emission area EA, but is not limited thereto. The light-blocking layer LS may be disposed in only one of the light emission area or the area other than the light emission area EA.

The display device 10 according to one or more embodiments may include a groove GRV passing through at least a portion of the thin film encapsulation layer TFEL and at least a portion of the touch sensor layer TSU.

The groove GRV may overlap the second encapsulation layer TFE2 and the third encapsulation layer TFE3 of the thin film encapsulation layer TFEL, the first touch insulating layer SIL1 of the touch sensor layer TSU, the second touch insulating layer SIL2 and the third touch insulating layer SIL3 of the touch sensor layer TSU, and the planarization layer PAS in the horizontal direction. For example, the groove GRV may pass through a portion of the second encapsulation layer TFE2 of the thin film encapsulation layer TFEL, the third encapsulation layer TFE3, the first touch insulating layer SIL1, the second touch insulating layer SIL2 and the third touch insulating layer SIL3 of the touch sensor layer TSU, and the planarization layer PAS. A bottom surface of the groove GRV may be positioned between an upper surface and a lower surface of the second encapsulation layer TFE2 in the third direction DR3.

The groove GRV may overlap the light-blocking layer LS in the third direction DR3. In an example in which the plurality of light-blocking layers LS are disposed along the horizontal direction, the groove GRV may be disposed in the horizontal direction while overlapping the light-blocking layer LS in the third direction DR3. The light-blocking layer LS and the groove GRV may not overlap the first touch electrode REL and the second touch electrode TEL in the third direction DR3. The light-blocking layer LS and the groove GRV may be disposed between the first touch electrode REL and the second touch electrode TEL in the horizontal direction.

At least a portion of the light-blocking layer LS may overlap the groove GRV in the horizontal direction. For example, a lower end portion of the light-blocking layer LS may be disposed in the groove GRV. The light-blocking layer LS may be disposed on the bottom surface GRVa of the groove GRV. The lower end portion of the light-blocking layer LS may overlap at least a portion of the thin film encapsulation layer TFEL and at least a portion of the touch sensor layer TSU in the horizontal direction.

At least a portion of the light-transmitting layer LT may be disposed in the groove GRV. For example, in an area in which the groove GRV is not disposed, the light-transmitting layer LT may be disposed on the touch sensor layer TSU, and in an area in which the groove GRV is disposed, the light-transmitting layer LT may be disposed on the bottom surface GRVa of the groove GRV.

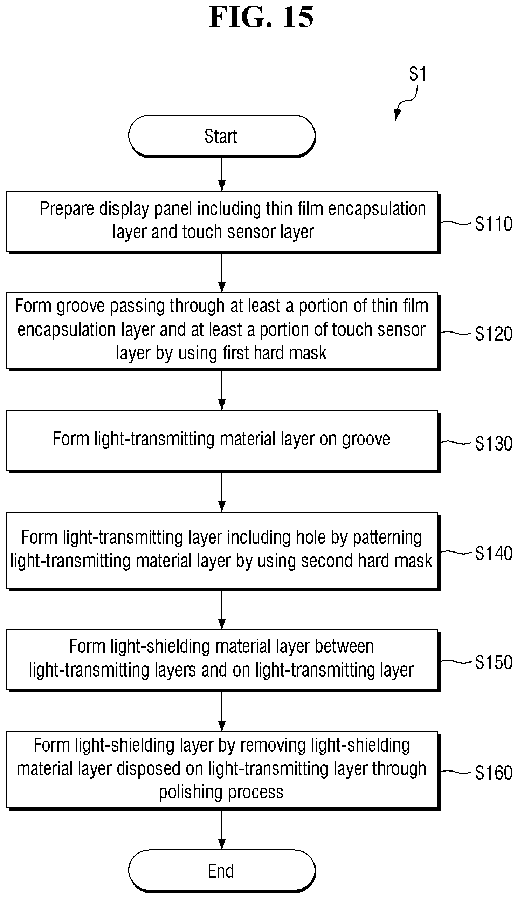

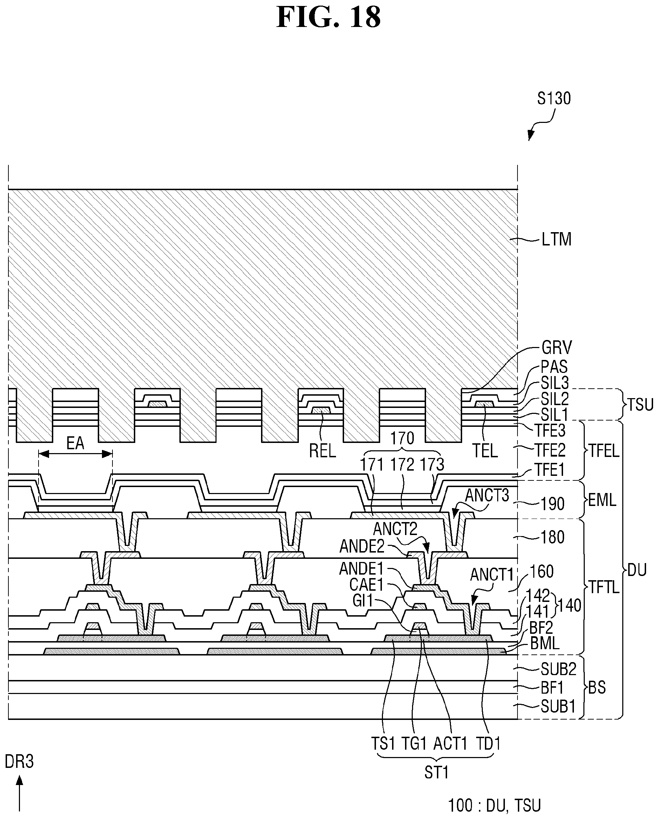

The width W_GRV of the groove GRV may be greater than the width W_LS of the light-blocking layer LS. For example, as in a method S1 (see FIG. 15) for manufacturing a display device according to an embodiment, which will be described later with reference to FIG. 15, in an example in which the groove GRV is first formed before a light-transmitting material layer LTM (see FIG. 18) constituting the light-transmitting layer LT is formed, the width W_GRV of the groove GRV may be formed to be greater than the width W_LS of the light-blocking layer LS in consideration of design tolerance for forming the light-blocking layer LS in the groove GRV.

In the present disclosure, the width W_GRV of the groove GRV, the width W_LS of the light-blocking layer LS, and the width W_LT of the light-transmitting layer LT mean an average value of the widths in the horizontal direction. For example, in the drawing, sides of the groove GRV, the light-blocking layer LS, and the light-transmitting layer LT are illustrated as being vertical surfaces, but are not limited thereto. In an example in which the sides of the groove GRV, the light-blocking layer LS, and the light-transmitting layer LT are inclined or curved, the width W_GRV of the groove GRV, the width W_LS of the light-blocking layer LS, and the width W_LT of the light-transmitting layer LT may be different for each point in the third direction DR3. In this case, for example, the width W_GRV of the groove GRV, the width W_LS of the light-blocking layer LS, and the width W_LT of the light-transmitting layer LT mean the average value of the widths in the horizontal direction.

The sides of the groove GRV may not be in contact with sides of the light-blocking layer LS. For example, the light-transmitting layer LT may be disposed between the sides of the light-blocking layer LS and the sides of the groove GRV in the groove GRV. Therefore, the sides of the groove GRV may not be in contact with the sides of the light-blocking layer LS.

The display device 10 according to one or more embodiments includes the groove GRV passing through at least a portion of the thin film encapsulation layer TFEL and at least a portion of the touch sensor layer TSU, thereby increasing a thickness H_LS of the light-blocking layer LS. For example, as the thickness H_LS of the light-blocking layer LS is increased, viewing angle control characteristics of the light control layer LCL may be improved.

As the display device 10 includes the groove GRV, a distance between the light-blocking layer LS and the light emitting layer 172 in the third direction DR3 may be reduced. Therefore, for example, based on the reduced distance, viewing angle control characteristics of the light control layer LCL may be improved.

As the display device 10 includes the groove GRV, the amount of the light-transmitting layer LT, which is increased together when the thickness H_LS of the light-blocking layer LS is increased, may be minimized. For example, as the display device 10 includes the groove GRV, the amount of the light-transmitting layer LT, which is increased together when the thickness H_LS of the light-blocking layer LS is increased, may be equal to the amount of the light-transmitting layer LT disposed in the groove GRV, except the amount equivalent to the thickness H_LT of the light-transmitting layer LT that does not overlap the groove GRV. As a result, in the display device 10 according to one or more embodiments, the total amount of the light-transmitting layer LT may be smaller than the amount of the light-transmitting layer LT disposed to form the thickness H_LS of the same light-blocking layer LS on the touch sensor layer TSU without the groove GRV. This is because of the thin film encapsulation layer TFEL and the touch sensor layer TSU, which are not removed between adjacent grooves GRV.

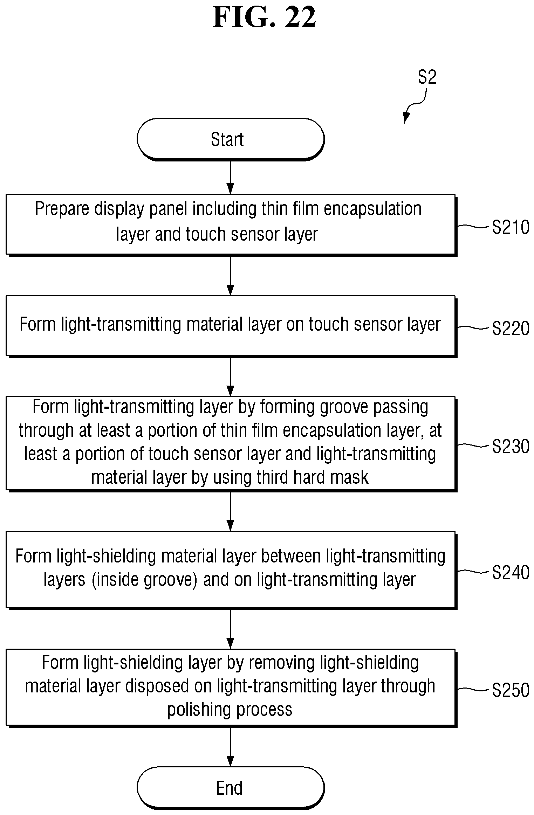

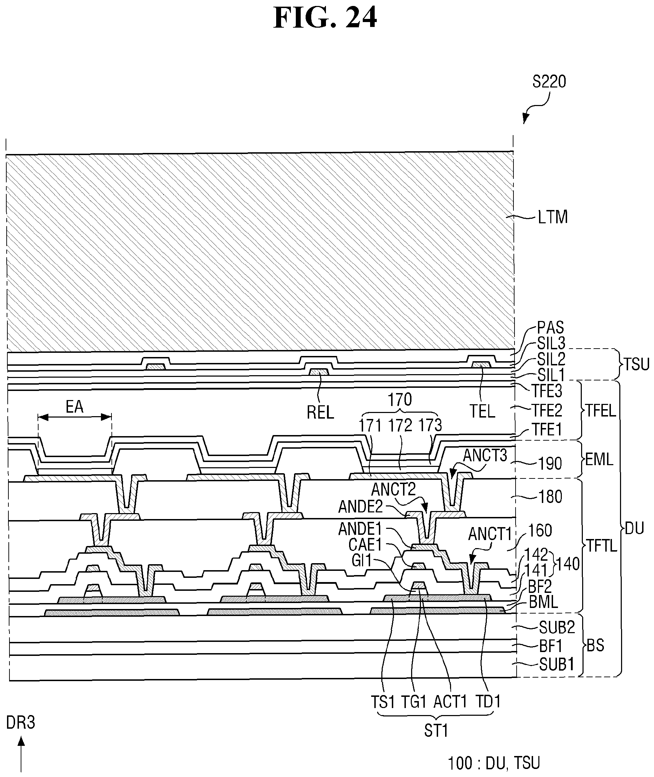

Since the increased amount of the light-transmitting layer LT is minimized as described herein, in an example in which the process of forming the light-transmitting layer LT is performed as illustrated in step S130 (see FIG. 18) and step S220 (see FIG. 24) of methods S1 and S2 (see FIGS. 15 and 22) for manufacturing a display device, which will be described later, the emission amount of out-gas caused by heat may be minimized. Therefore, aspects of the methods S1 and S2 may prevent a film burst phenomenon of the light-transmitting layer LT due to the out-gas.

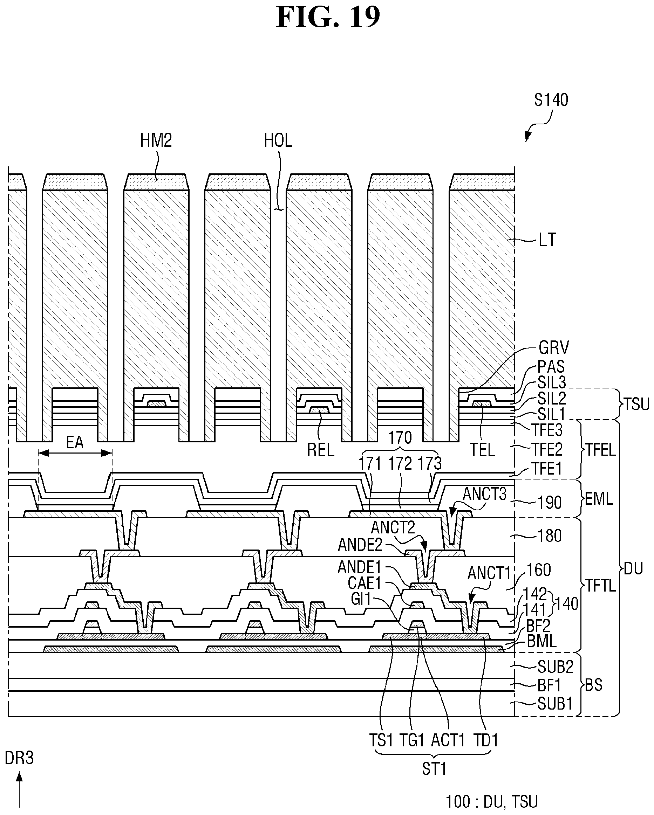

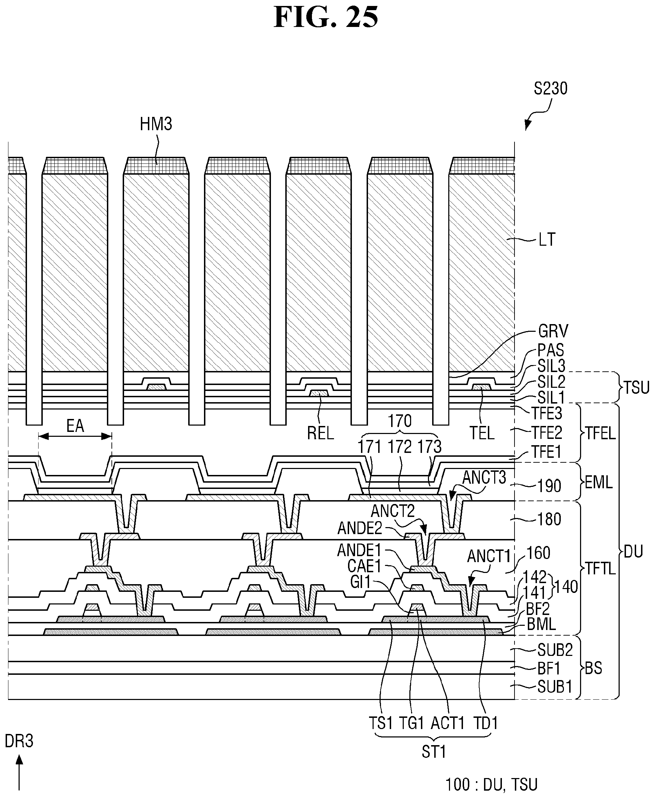

Since the increased amount of the light-transmitting layer LT is minimized, thicknesses of the second and third hard masks HM2 and HM3 may be minimized during a patterning process of the light-transmitting layer LT as illustrated in step S140 (see FIG. 19) and step S230 (see FIG. 25) of the methods S1 and S2 (see FIGS. 15 and 22) for manufacturing a display device, which will be described later. For example, aspects of the methods S1 and S2 may support determining the thicknesses of the second and third hard masks HM2 and HM3 in consideration of the amount of the light-transmitting layer LT and etch rates of the light-transmitting layer LT and the second and third hard masks HM2 and HM3. Since the increased amount of the light-transmitting layer LT is minimized, an increase in the thicknesses of the second and third hard masks HM2 and HM3 may be also minimized. As a result, bending of the display panel 100 due to a weight of the hard mask during the patterning process may be prevented.

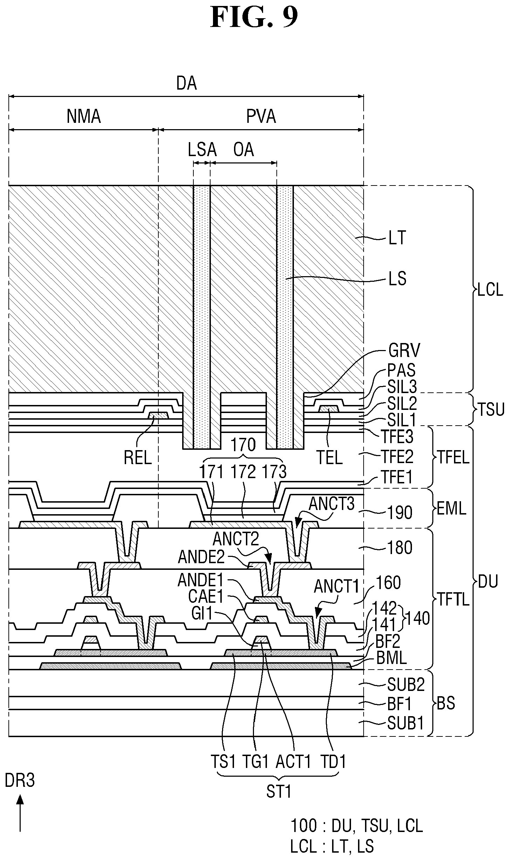

FIG. 9 is a cross-sectional view illustrating a display panel and a light control layer in a normal mode area and a privacy mode area of a display device according to an embodiment.

Referring to FIG. 9 in addition to FIGS. 1 to 3, 7a, 7b and 8, the display device 10 may include a normal mode area NMA and a privacy mode area PVA.

The normal mode area NMA and the privacy mode area PVA may be included in the display area DA. The normal mode area NMA may refer to an area in which the light-blocking layer LS is not disposed, and the privacy mode area PVA may refer to an area in which the light-blocking layer LS is disposed.

In the normal mode area NMA, only the transmissive area OA (in which the light-shielding layer LS is not disposed) may be disposed. In the normal mode area NMA, only the light-transmitting layer LT may be disposed.

The non-transmissive area LSA and the transmissive area OA may be alternately disposed in the privacy mode area PVA. The light-transmitting layer LT and the light-blocking layer LS may be alternately disposed in the privacy mode area PVA.

The normal mode area NMA and the privacy mode area PVA may be alternately disposed throughout the display area DA. For example, the normal mode area NMA and the privacy mode area PVA may be disposed along the first direction DR1 and the second direction DR2 like the pixel PX of FIG. 1. In this case, for example, the normal mode area NMA and the privacy mode area PVA may be alternately disposed along the first direction DR1 and the second direction DR2.

When the user operates a normal mode, the light emitting layer 172 of one or more pixels PX disposed in the normal mode area NMA may emit light, and other instances of the light emitting layer 172 disposed in other areas different from the normal mode area NMA may refrain from emitting light. When the user operates a privacy mode, the light emitting layer 172 of the pixel PX disposed in the privacy mode area PVA may emit light, and other instances of the light emitting layer 172 disposed in other areas different from the privacy mode are PVA may refrain from emitting light.

Therefore, the viewing angle control effect of the light control layer LCL is not generated in the normal mode, and the viewing angle control effect of the light control layer LCL is generated in the privacy mode.

As described herein with reference to FIG. 7a, the display device 10 may include only the privacy mode area PVA as the light-blocking layer LS is disposed over the entire display area DA.

Hereinafter, other embodiments of the display device will be described. In the following embodiments, the same elements as those of the previous embodiments will be referred to as the same reference numerals, and their redundant descriptions will be omitted or simplified and the following description will be based on differences from the previous embodiments.

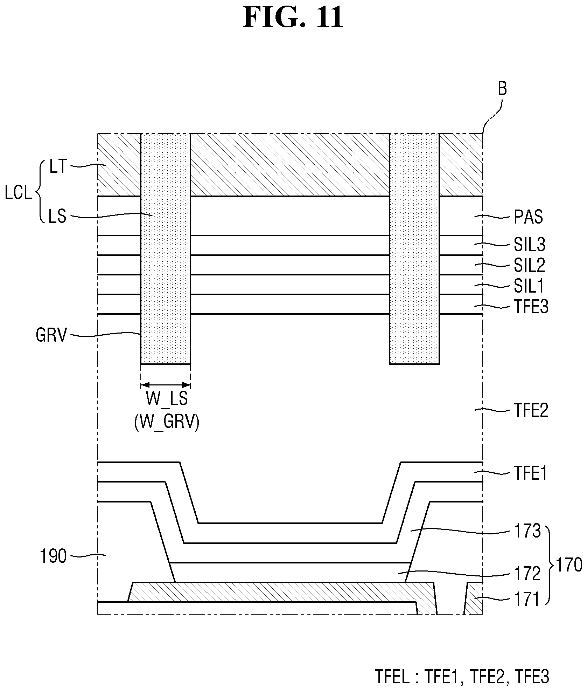

FIG. 10 is a cross-sectional view illustrating a display panel and a light control layer of a display device according to another embodiment. FIG. 11 is an enlarged view illustrating an area B of FIG. 10.

Referring to FIGS. 10 and 11, the display device 10 includes aspects of the display device 10 described with reference to FIG. 7a, and repeated descriptions of like elements are omitted for brevity. The display device 10 now described is different from the display device 10 described with reference to FIG. 7a in that the width W_GRV of the groove GRV and the width W_LS of the light-blocking layer LS are equal to each other.

In more detail, the width W_GRV of the groove GRV may be equal to the width W_LS of the light-blocking layer LS. For example, as in the method S2 (see FIG. 22) for manufacturing a display device, which will be described later with reference to FIG. 22, in an example in which the groove GRV is formed after a light-transmitting material layer LTM (see FIG. 24) constituting the light-transmitting layer LT is formed, the width W_GRV of the groove GRV may be equal to the width W_LS of the light-blocking layer LS.

The sides of the groove GRV may be in contact with sides of the light-blocking layer LS. For example, in the groove GRV, the light-transmitting layer LT may not be disposed between the sides of the light-blocking layer LS and the sides of the groove GRV. Therefore, the sides of the groove GRV may be in contact with sides of the light-blocking layer LS. That is, the sides of the light-blocking layer LS in the groove GRV may be in contact with the thin film encapsulation layer TFEL and the touch sensor layer TSU.

The display device 10 as described includes the groove GRV passing through at least a portion of the thin film encapsulation layer TFEL and at least a portion of the touch sensor layer TSU, thereby increasing the thickness H_LS of the light-blocking layer LS (and in some cases, only the thickness H_LS of the light-blocking layer LS) without increasing the thickness H_LT of the light-transmitting layer LT. As the thickness H_LS of the light-blocking layer LS is increased, viewing angle control characteristics of the light control layer LCL may be improved.

As the display device 10 includes the groove GRV, the distance between the light-blocking layer LS and the light emitting layer 172 in the third direction DR3 may be reduced. Therefore, viewing angle control characteristics of the light control layer LCL may be improved.

Since the thickness H_LT of the light-transmitting layer LT is not increased, in an example in which the process of forming the light-transmitting layer LT is performed as illustrated in step S130 (see FIG. 18) and step S220 (see FIG. 24) of the methods S1 and S2 (see FIGS. 15 and 22) for manufacturing a display device, which will be described later, the emission amount of out-gas caused by heat may be minimized. Therefore, a film burst phenomenon of the light-transmitting layer LT, which is due to the out-gas, may be avoided.

Since the thickness H_LT of the light-transmitting layer LT is not increased, the thicknesses of the second and third hard masks HM2 and HM3 may be minimized during a patterning process of the light-transmitting layer LT as illustrated in step S140 (see FIG. 19) and step S230 (see FIG. 25) of the methods S1 and S2 (see FIGS. 15 and 22) for manufacturing a display device, which will be described later. For example, the thicknesses of the second and third hard masks HM2 and HM3 may be determined in consideration of the thickness H_LT of the light-transmitting layer LT and etch rates of the light-transmitting layer LT and the second and third hard masks HM2 and HM3. In this case, for example, since the thickness H_LT of the light-transmitting layer LT is not increased, the thicknesses of the second and third hard masks HM2 and HM3 may not be increased. As a result, bending of the display panel 100 due to a weight of the hard mask during the patterning process may be prevented.

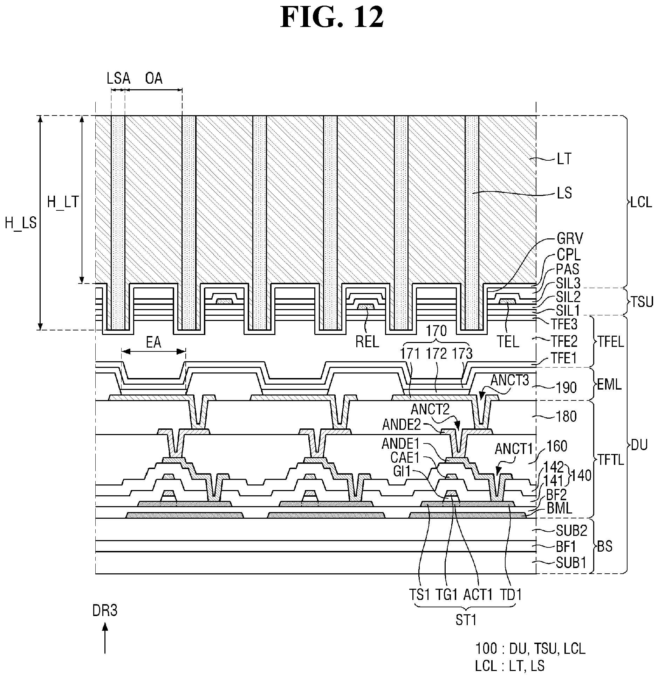

FIG. 12 is a cross-sectional view illustrating a display panel, a capping layer, and a light control layer of a display device according to another embodiment.

Referring to FIG. 12, the display device 10 includes aspects of the display device 10 described with reference to FIGS. 7a and 10, and repeated descriptions of like elements are omitted for brevity. The display device 10 now described is different from the display device 10 according to the embodiments described herein with reference to FIGS. 7a and 10 in that the display device 10 further includes a capping layer CPL.

In more detail, the display device 10 according to one or more embodiments may further include a capping layer CPL.

The capping layer CPL may be disposed on the groove GRV. For example, the capping layer CPL may be disposed on the groove GRV, the thin film encapsulation layer TFEL, and the touch sensor layer TSU. The capping layer CPL may completely cover upper surfaces and sides of the groove GRV, the thin film encapsulation layer TFEL, and the touch sensor layer TSU.

In the drawing, the capping layer CPL is illustrated as one layer, but it is not limited thereto. The capping layer CPL may include one layer or a plurality of stacked structures.

The capping layer CPL may prevent oxygen or moisture from permeating into the light emitting element layer EML. The capping layer CPL may include at least one inorganic layer. The inorganic layer may be a silicon nitride layer, a silicon oxynitride layer, a silicon oxide layer, a titanium oxide layer, or an aluminum oxide layer, but is not limited thereto.

The capping layer CPL may protect the light emitting element layer EML from particles such as, for example, dust. The capping layer CPL may include at least one organic layer. The organic layer may be an acryl resin, an epoxy resin, a phenolic resin, a polyamide resin, or a polyimide resin, but is not limited thereto.

The material included in the capping layer CPL may be the same as the material included in the thin film transistor layer TFEL. In an example in which the capping layer CPL includes at least one inorganic layer, the capping layer CPL may include the same material (at least one inorganic layer) as the material included in the first encapsulation layer TFE1 and/or the third encapsulation layer TFE3. In an example in which the capping layer CPL includes at least one organic layer, the capping layer CPL may include the same material (at least one organic layer) as the material included in the second encapsulation layer TFE2.

As the display device 10 according to one or more embodiments may further include the capping layer CPL, permeation of oxygen, moisture and dust may be avoided even though a portion of the thin film encapsulation layer TFEL is penetrated by the groove GRV. Therefore, reliability of the display device 10 may be improved.

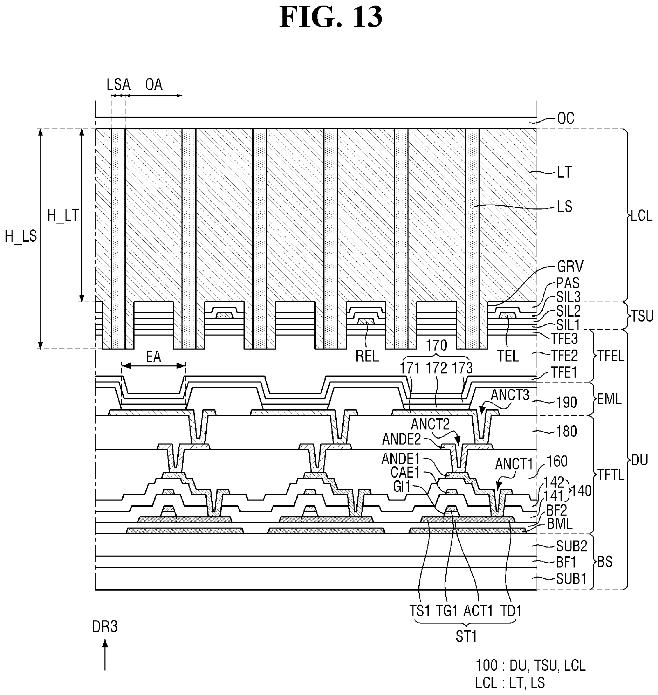

FIG. 13 is a cross-sectional view illustrating a display panel, a light control layer, and an overcoat layer of a display device according to a further embodiment.

Referring to FIG. 13, the display device 10 includes aspects of the display device 10 described with reference to FIGS. 7a, 10 and 12, and repeated descriptions of like elements are omitted for brevity. The display device 10 now described is different from the display device 10 according to the embodiments described herein with reference to FIGS. 7a, 10 and 12 in that the display device 10 further includes an overcoat layer OC.

In more detail, the display device 10 according to one or more embodiments may further include an overcoat layer OC.

The overcoat layer OC may be disposed on the light control layer LCL. For example, the overcoat layer OC may be disposed on the light-transmitting layer LT and the light-blocking layer LS. The overcoat layer OC may be disposed over the entire surface of the light control layer LCL.

The overcoat layer OC may planarize the upper surface of the light control layer LCL and protect the light control layer LCL. The overcoat layer OC may include an organic material. For example, the overcoat layer OC may include at least one of an acryl resin, an epoxy resin, a phenolic resin, a polyamide resin or a polyimide resin.

As the display device 10 according to one or more embodiments further includes the overcoat layer OC, durability of the light control layer LCL may be improved. Therefore, reliability of the display device 10 may be improved.

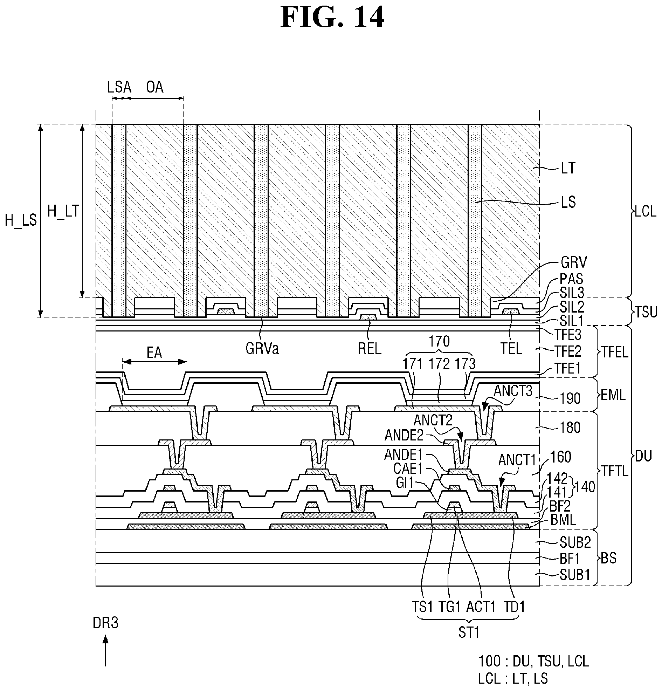

FIG. 14 is a cross-sectional view illustrating a display panel and a light control layer of a display device according to another embodiment.

Referring to FIG. 14, the display device 10 includes aspects of the display device 10 described with reference to FIGS. 7a, 10, 12, and 13 and repeated descriptions of like elements are omitted for brevity. The display device 10 now described is different from the display device 10 according to the embodiments described herein with reference to FIGS. 7a, 10, 12 and 13 in a difference in depth of the groove GRV.

In more detail, the depth of the groove GRV in the display device 10 described here may be different from that of the groove in the display device 10 according to the aforementioned embodiments.

As illustrated in the drawing, the bottom surface GRVa of the groove GRV may be disposed in the touch sensor layer TSU in the third direction DR3. For example, the bottom surface GRVa of the groove GRV may be disposed between the upper surface of the first touch insulating layer SIL1 and the lower surface of the second touch insulating layer SIL3 in the third direction DR3.

In this case, for example, the depth of the groove GRV in the display device 10 now describedmay be smaller than that of the groove GRV in the display device 10 according to the aforementioned embodiments.

Various modifications may be made with respect to the depth of the groove GRV. For example, various modifications may be made with respect to the depth of the groove GRV based on a target thickness H_LS of the light-blocking layer LS (e.g., a target thickness associated with achieving target characteristics of the light-blocking layer LS). For example, as illustrated in FIG. 14, the bottom surface GRVa of the groove GRV may overlap the touch sensor layer TSU in the horizontal direction. In another example, as in the embodiments described herein, the bottom surface GRVa of the groove GRV may overlap the thin film encapsulation layer TFEL in the horizontal direction.

The bottom surface GRVa of the groove GRV may overlap the planarization layer PAS in the horizontal direction. In another example, the bottom surface GRVa of the groove GRV may overlap the third touch insulating layer SIL3 in the horizontal direction. In another example, the bottom surface GRVa of the groove GRV may overlap the second touch insulating layer SIL2 in the horizontal direction. In another example, the bottom surface GRVa of the groove GRV may overlap the first touch insulating layer SIL1 in the horizontal direction. In another example, the bottom surface GRVa of the groove GRV may overlap the third encapsulation layer TFE3 in the horizontal direction. In another example, the bottom surface GRVa of the groove GRV may overlap the second encapsulation layer TFE2 in the horizontal direction. In another example, the bottom surface GRVa of the groove GRV may overlap the first encapsulation layer TFE1 in the horizontal direction.

Hereinafter, a method for manufacturing a display device according to an embodiment will be described.

In the descriptions of the methods herein, the operations may be performed in a different order than the order shown or described, or the operations may be performed in different orders or at different times. Certain operations may also be left out of the methods, one or more operations may be repeated, or other operations may be added.

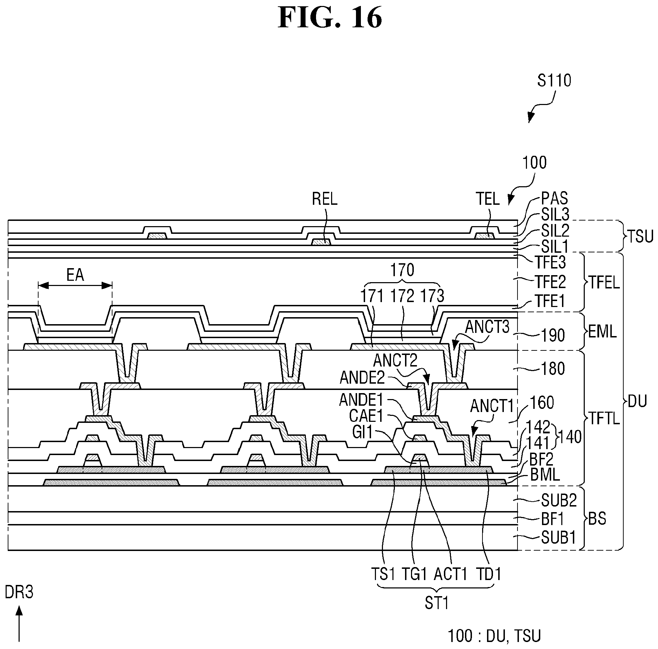

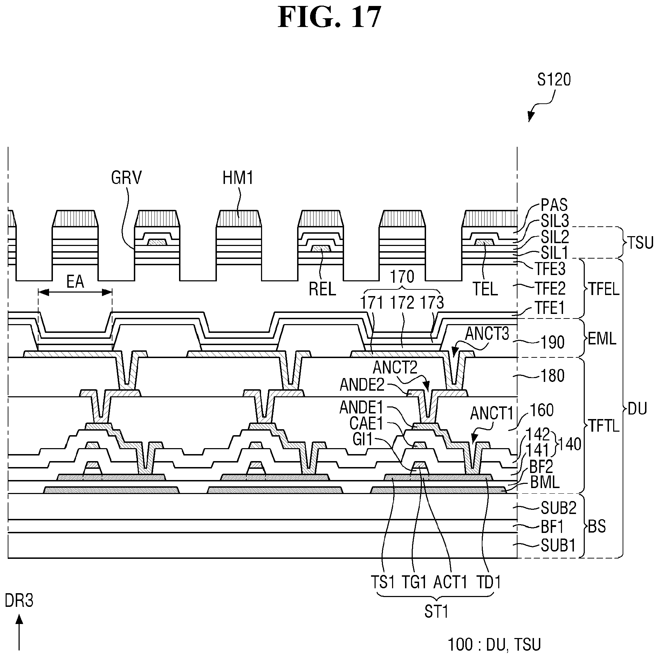

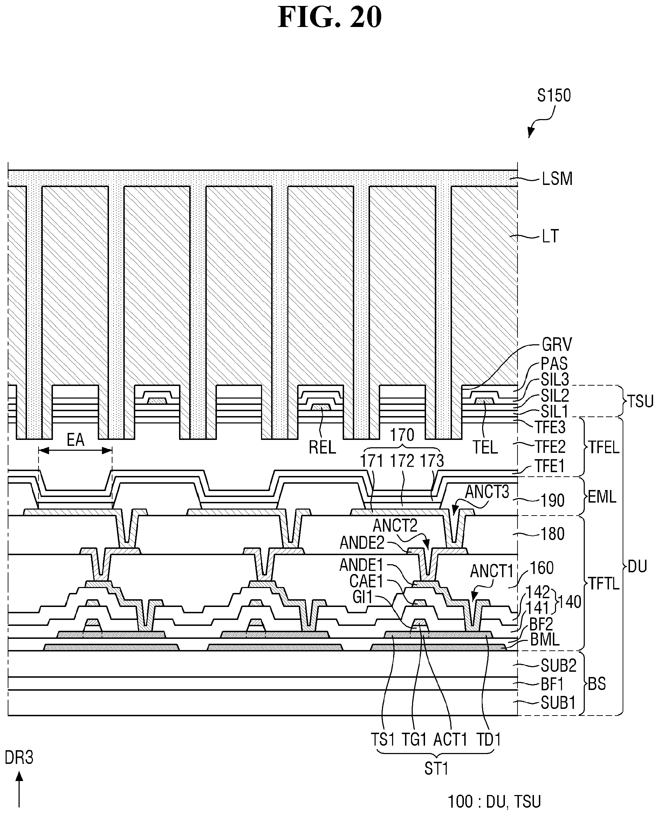

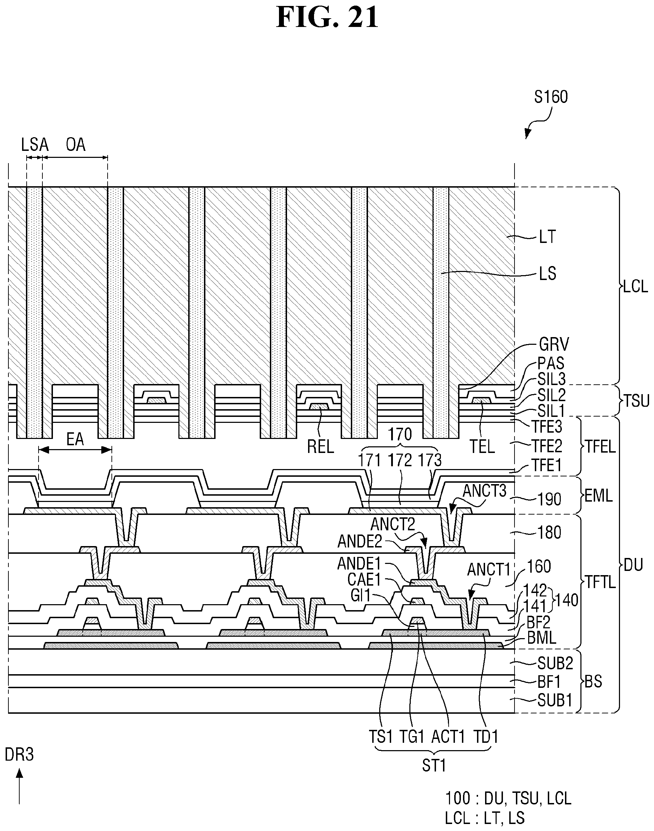

FIG. 15 is a flow chart illustrating a method S1 for manufacturing a display device according to an embodiment. FIG. 16 is a cross-sectional view illustrating step S110 of FIG. 15. FIG. 17 is a cross-sectional view illustrating step S120 of FIG. 15. FIG. 18 is a cross-sectional view illustrating step S130 of FIG. 15. FIG. 19 is a cross-sectional view illustrating step S140 of FIG. 15. FIG. 20 is a cross-sectional view illustrating step S150 of FIG. 15. FIG. 21 is a cross-sectional view illustrating step S160 of FIG. 15.

Referring to FIGS. 15 to 21, the method S1 for manufacturing a display device may include a step S110 of preparing a display panel, a step S120 of forming a groove passing through at least a portion of a thin film encapsulation layer and at least a portion of a touch sensor layer, a step S130 of forming a light-transmitting material layer on the groove, a step S140 of forming a light-transmitting layer by patterning the light-transmitting material layer, a step S150 of forming a light-blocking material layer between the light-transmitting layers and on the light-transmitting layer, and a step S160 of forming a light-blocking layer by removing the light-blocking material layer disposed on the light-transmitting layer.

First, in the step S110 of preparing a display panel, the method S1 may include preparing the display panel 100 including a thin film encapsulation layer TFEL and a touch sensor layer TSU.

Second, in the step S120 of forming a groove passing through at least a portion of the thin film encapsulation layer and at least a portion of the touch sensor layer, the method S1 may include removing at least a portion of the thin film encapsulation layer TFEL and at least a portion of the touch sensor layer TSU.

For example, the method S1 may include etching a portion of the second encapsulation layer TFE2, the third encapsulation layer TFE3, the first to third touch insulating layers SIL1, SIL2, and SIL3, and the planarization layer PAS using the first hard mask HM1.

Therefore, the groove GRV passing through a portion of the second encapsulation layer TFE2, the third encapsulation layer TFE3, the first to third touch insulating layers SIL1, SIL2, and SIL3, and the planarization layer PAS may be formed.

However, as described herein, since various modifications may be made in the depth of the groove GRV, the depth of the removed layer may be variously modified.

Third, in the step S130 of forming the light-transmitting material layer on the groove, the method S1 may include disposing the light-transmitting material layer LTM on the groove GRV. The light-transmitting material layer LTM may completely fill the inside of the groove GRV. In an example in which the inside of the groove GRV is completely filled, the light-transmitting material layer LTM may be stacked on the touch sensor layer TSU.

The light-transmitting material layer LTM may include an organic layer such as, for example, an acryl resin, an epoxy resin, a phenolic resin, a polyamide resin, and a polyimide resin. The light-transmitting layer LT may include silicon oxynitride or silicon oxide.

Fourth, in the step S140 of forming the light-transmitting layer by patterning the light-transmitting material layer, the method S1 may include removing at least a portion of the light-transmitting material layer LTM.

For example, the method S1 may include etching at least a portion of the light-transmitting material layer LTM using the second hard mask HM2. The portion from which the light-transmitting material layer LTM is etched may overlap the groove GRV in the third direction DR3. The method S1 may include forming a hole HOL in the portion from which the light-transmitting material layer LTM is etched. Therefore, the light-transmitting layer LT may be formed.

Fifth, in the step S150 of forming the light-blocking material layer between the light-transmitting layers and on the light-transmitting layer, the method S1 may include disposing the light-blocking material layer LSM between the light-transmitting layers LT and on the light-transmitting layers LT. The light-blocking material layer LSM may completely fill the inside of the hole HOL. In an example in which the inside of the hole HOL is completely filled, a portion of the light-blocking material layer LSM may overflow on the light-transmitting layer LT such that the light-blocking material layer LSM is disposed even on the light-transmitting layer LT.

The light-blocking layer LS may include a light-blocking organic material. For example, the light-blocking layer LS is a photosensitive resin capable of absorbing or shielding light, and may include an organic material that includes an organic black pigment such as, for example, carbon black.

Sixth, in the step S160 of forming the light-blocking layer by removing the light-blocking material layer disposed on the light-transmitting layer, the method S1 may include removing the light-blocking material layer LSM overflowing onto the light-transmitting layer LT.

For example, the light-blocking material layer LSM disposed on the light-transmitting layer LT may be removed through a polishing process such as, for example, a Chemical Mechanical Polishing (CMP) process. Therefore, the light-blocking material layer LSM disposed between the light-transmitting layers LT may remain, and the light-blocking layer LS may be formed. In some examples, only the light-blocking material layer LSM disposed between the light-transmitting layers LT may remain. and the light-blocking layer LS may be formed.

However, in an example in which the light-blocking material layer LSM does not overflow onto the light-transmitting layer LT in the step S150, the step S160 may be omitted.

In the method S1 for manufacturing the display device, the groove GRV passing through at least a portion of the thin film encapsulation layer TFEL and at least a portion of the touch sensor layer TSU is formed, such that the thickness H_LS of the light-blocking layer LS may be increased. For example, as the thickness H_LS of the light-blocking layer LS is increased, viewing angle control characteristics of the light control layer LCL may be improved.

In the method S1 for manufacturing the display device, as the groove GRV is formed, the distance between the light-blocking layer LS and the light emitting layer 172 in the third direction DR3 may be reduced. Therefore, viewing angle control characteristics of the light control layer LCL may be improved.

In the method S1 for manufacturing the display device, as described herein, in an example in which the thickness H_LS of the light-blocking layer LS is increased, the amount of the light-transmitting layer LT that is increased together with the thickness H_LS of the light-blocking layer LS may be minimized. Since the increased amount of the light-transmitting layer LT is minimized, the emission amount of out-gas caused by heat may be minimized during the process of forming the light-transmitting layer LT. Therefore, aspects of the method S1 described herein may prevent a film burst phenomenon of the light-transmitting layer LT due to the out-gas.

Since the increased amount of the light-transmitting layer LT is minimized, the thickness of the second hard mask HM2 may be minimized during a patterning process of the light-transmitting layer LT. For example, since the increased amount of the light-transmitting layer LT is minimized, an increase in the thickness of the second hard mask HM2 may be minimized. As a result, bending of the display panel 100 due to the weight of the hard mask during the patterning process may be prevented.

Hereinafter, other embodiments of the display device according to an embodiment will be described. In the following embodiments, the same elements as those of the previous embodiments will be referred to as the same reference numerals, and their redundant descriptions will be omitted or simplified and the following description will be based on differences from the previous embodiments.

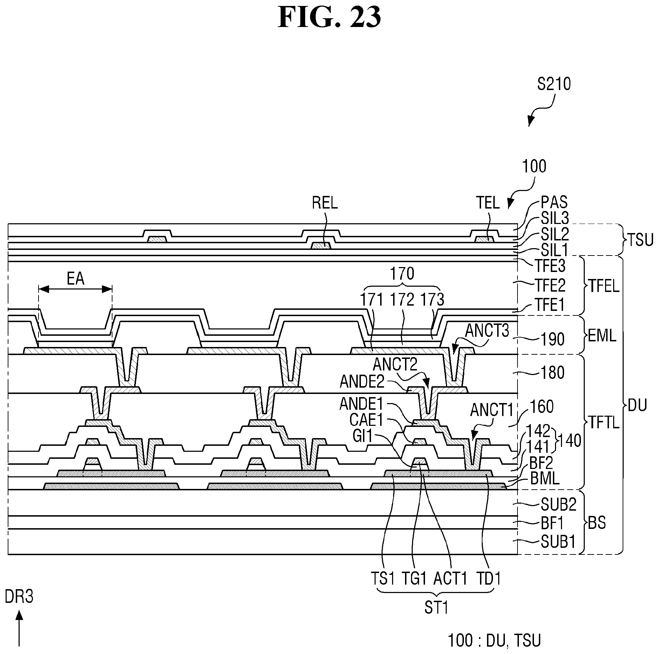

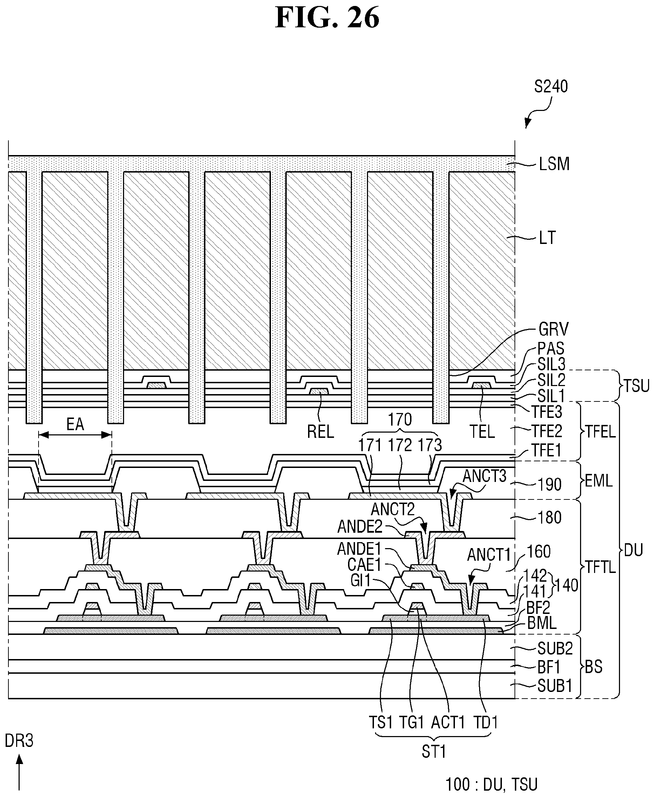

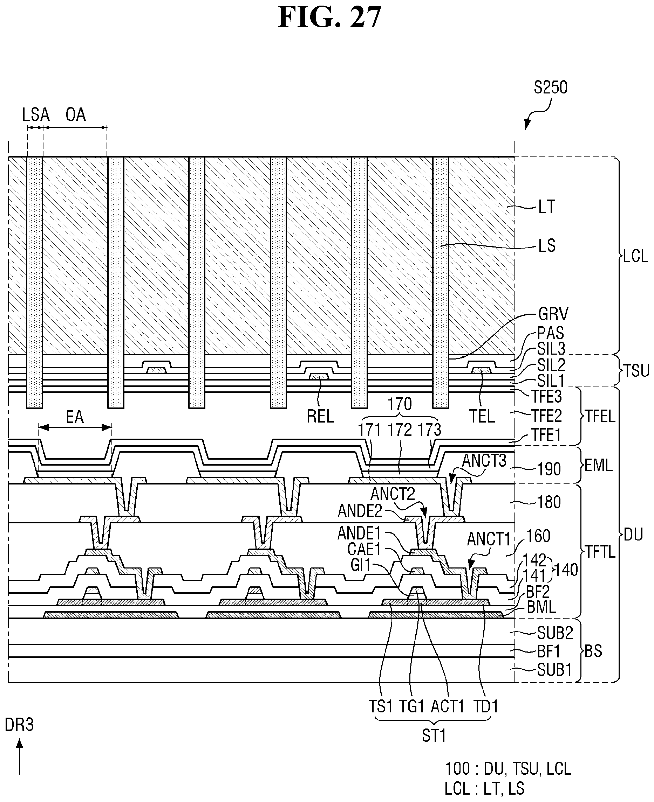

FIG. 22 is a flow chart illustrating a method S2 for manufacturing a display device according to an embodiment. FIG. 23 is a cross-sectional view illustrating step S210 of FIG. 22. FIG. 24 is a cross-sectional view illustrating step S220 of FIG. 22. FIG. 25 is a cross-sectional view illustrating step S230 of FIG. 22. FIG. 26 is a cross-sectional view illustrating step S240 of FIG. 22. FIG. 27 is a cross-sectional view illustrating step S250 of FIG. 22.

Referring to FIGS. 22 to 27, the method S2 includes aspects of the method S1 described with reference to FIG. 15, and repeated descriptions of like elements are omitted for brevity. The method S2 for manufacturing a display device is different from the method S1 described with reference to FIG. 15 in that the groove GRV is formed after the light-transmitting material layer LTM is formed.

In more detail, the method S2 for manufacturing a display device may include a step S210 of preparing a display panel, a step S220 of forming a light-transmitting material layer on a touch sensor layer, a step S230 of forming a light-transmitting layer by forming a groove passing through at least a portion of a thin film encapsulation layer, at least a portion of the touch sensor layer, and the light-transmitting material layer, a step S240 of forming a light-transmitting material layer between the light-transmitting layer (inside the groove) and on the light-transmitting layer, and a step S250 of forming a light-blocking layer by removing the light-blocking material layer disposed on the light-transmitting layer.

First, in the step S210 of preparing a display panel, the method S2 may include preparing the display panel 100 including a thin film encapsulation layer TFEL and a touch sensor layer TSU.

Second, in the step S220 of forming a light-transmitting material layer on the touch sensor layer, the method S2 may include disposing the light-transmitting material layer LTM on the touch sensor layer TSU. The light-transmitting material layer LTM may be disposed on the upper surface of the touch sensor layer TSU. In an embodiment, the light-transmitting material layer LTM may be disposed on the entire surface on the upper surface of the touch sensor layer TSU.

Third, in the step S230 of forming the light-transmitting layer by forming the groove passing through at least a portion of the thin film encapsulation layer, the method S2 may include removing at least a portion of the touch sensor layer and the light-transmitting material layer, the light-transmitting material layer LTM, at least a portion of the thin film encapsulation layer TFEL, and at least a portion of the touch sensor layer TSU.

For example, the method S2 may include etching a portion of the light-transmitting material layer LTM, the second encapsulation layer TFE2, the third encapsulation layer TFE3, the first to third touch insulating layers SIL1, SIL2, and SIL3, and the planarization layer PAS using the third hard mask HM3.

Therefore, the groove GRV passing through the light-transmitting material layer LTM, a portion of the second encapsulation layer TFE2, the third encapsulation layer TFE3, the first to third touch insulating layers SIL1, SIL2, and SIL3, and the planarization layer PAS may be formed.

However, as described herein, since various modifications may be made in the depth of the groove GRV, the depth of the removed layer may be variously modified.

Fourth, in the step S240 of forming the light-blocking material layer between the light-transmitting layers (inside the groove) and on the light-transmitting layer, the method S2 may include disposing the light-blocking material layer LSM between the light-transmitting layers LT and on the light-transmitting layer LT.

For example, the light-blocking material layer LSM may completely fill between the light-transmitting layers LT, for example, the inside of the groove GRV. In an example in which the inside of the groove GRV is completely filled, a portion of the light-blocking material layer LSM may overflow onto the light-transmitting layer LT such that the light-blocking material layer LSM is disposed even on the light-transmitting layer LT.

Fifth, in the step S250 of forming the light-blocking layer by removing the light-blocking material layer disposed on the light-transmitting layer, the method S2 may include removing the light-blocking material layer LSM overflowing onto the light-transmitting layer LT.

For example, the light-blocking material layer LSM disposed on the light-transmitting layer LT may be removed through a polishing process such as, for example, a Chemical Mechanical Polishing (CMP) process. Therefore, the light-blocking material layer LSM disposed between the light-transmitting layers LT may remain, and the light-blocking layer LS may be formed. In some examples, only the light-blocking material layer LSM disposed between the light-transmitting layers LT may remain, and the light-blocking layer LS may be formed.

However, in an example in which the light-blocking material layer LSM does not overflow onto the light-transmitting layer LT in the step S250, the step S260 may be omitted.

In the method S2 for manufacturing the display device, as the display device includes the groove GRV passing through at least a portion of the thin film encapsulation layer TFEL and at least a portion of the touch sensor layer TSU, the thickness H_LS of the light-blocking layer LS (in some cases, only the thickness H_LS of the light-blocking layer LS) may be increased without increasing the thickness H_LT of the light-transmitting layer LT. As the thickness H_LS of the light-blocking layer LS is increased, viewing angle control characteristics of the light control layer LCL may be improved.

In the method S2 for manufacturing the display device, as the groove GRV is formed, the distance between the light-blocking layer LS and the light emitting layer 172 in the third direction DR3 may be reduced. Therefore, viewing angle control characteristics of the light control layer LCL may be improved.

In the method S2 for manufacturing the display device, since the thickness H_LT of the light-transmitting layer LT is not increased, the emission amount of out-gas caused by heat may be minimized during the process of forming the light-transmitting layer LT. Therefore, aspects of the method S1 described herein may prevent a film burst phenomenon of the light-transmitting layer LT, which is due to the out-gas.

Since the thickness H_LT of the light-transmitting layer LT is not increased, the thickness of the third hard mask HM3 may be minimized during the patterning process of the light-transmitting layer LT. For example, since the thickness H_LT of the light-transmitting layer LT is not increased, the thickness of the third hard mask HM3 may not be increased. As a result, bending of the display panel 100 due to the weight of the hard mask during the patterning process may be prevented.

Embodiments supported by the present disclosure have been described with reference to the accompanying drawings, in which one or more example embodiments are illustrated. Aspects supported by the present disclosure may, however, be embodied in different forms and should not be construed as limited to the embodiments set forth herein. Rather, these example embodiments are provided so that this disclosure will be thorough and complete, and will fully convey the scope of example aspects of the invention to those skilled in the art.

Terms such as, for example, first, second, and the like may be used to describe various components, but the components should not be limited by the terms. The terms as used herein may distinguish one component from other components and are not to be limited by the terms. For example, without departing the scope of the present disclosure, a first component may be referred to as a second component, and similarly, the second component may also be referred to as the first component. The terms of a singular form may include plural forms unless otherwise specified.

The terminology used herein is for the purpose of describing particular embodiments only and is not intended to be limiting. As used herein, *"*a*," "*an*," "*the*,"* and *"*at least one" do not denote a limitation of quantity, and are intended to include both the singular and plural, unless the context clearly indicates otherwise. For example, *"*an element" has the same meaning as *"*at least one element," unless the context clearly indicates otherwise. *"*At least one" is not to be construed as limiting *"*a*"* or *"*an.*" "*Or*"* means *"*and/or.*"* As used herein, the term *"*and/or*"* includes any and all combinations of one or more of the associated listed items. It will be further understood that the terms *"*comprises*"* and/or *"*comprising*,"* or *"*includes*"* and/or *"*including*"* when used in this specification, specify the presence of stated features, regions, integers, steps, operations, elements, and/or components, but do not preclude the presence or addition of one or more other features, regions, integers, steps, operations, elements, components, and/or groups thereof.

The terms *"*about*"* or *"*approximately*"* as used herein are inclusive of the stated value and include a suitable range of deviation for the particular value as determined by one of ordinary skill in the art, considering the measurement in question and the error associated with measurement of the particular quantity. The term *"*about*"* can mean within one or more standard deviations, or within ± 30%, 20%, 10%, 5% of the stated value, for example.

The term *"*substantially,*"* as used herein, means approximately or actually equal (e.g., within a threshold percent of equal). The term *"*substantially simultaneously*,"* as used herein, means approximately or actually at the same time (e.g., within a threshold percent of equal). The term *"*substantially the same*,"* as used herein, means approximately or actually the same (e.g., within a threshold difference amount).

Spatially relative terms, such as *"*beneath*," "*below*," "*lower*," "*above*," "*upper*"* and the like, may be used herein for ease of description to describe one element or feature's relationship to another element(s) or feature(s) as illustrated in the figures. It will be understood that the spatially relative terms are intended to encompass different orientations of the device in use or operation in addition to the orientation depicted in the figures. For example, if the device in the figures is turned over, elements described as *"*below*"* or *"*beneath*"* other elements or features would then be oriented *"*above*"* the other elements or features. Thus, the term *"*below*"* can encompass both an orientation of above and below. The device may be otherwise oriented (rotated 90 degrees or at other orientations) and the spatially relative descriptors used herein interpreted accordingly.

Embodiments are described herein with reference to cross section illustrations that are schematic illustrations of idealized embodiments. As such, variations from the shapes of the illustrations as a result, for example, of manufacturing techniques and/or tolerances, are to be expected. Thus, embodiments described herein should not be construed as limited to the particular shapes of regions as illustrated herein but are to include deviations in shapes that result, for example, from manufacturing. For example, a region illustrated or described as flat may, typically, have rough and/or nonlinear features. Moreover, sharp angles that are illustrated may be rounded. Thus, the regions illustrated in the figures are schematic in nature and their shapes are not intended to illustrate the precise shape of a region and are not intended to limit the scope of the present claims.

Unless otherwise defined, all terms (including technical and scientific terms) used herein have the same meaning as commonly understood by one of ordinary skill in the art to which this disclosure belongs. It will be further understood that terms, such as those defined in commonly used dictionaries, should be interpreted as having a meaning that is consistent with their meaning in the context of the relevant art and the present disclosure, and will not be interpreted in an idealized or overly formal sense unless expressly so defined herein.

It should be appreciated that various embodiments of the disclosure and the terms used therein are not intended to limit the technological features set forth herein to particular embodiments and include various changes, equivalents, or replacements for a corresponding embodiment. With regard to the description of the drawings, similar reference numerals may be used to refer to similar or related elements. It is to be understood that a singular form of a noun corresponding to an item may include one or more of the things, unless the relevant context clearly indicates otherwise. As used herein, each of such phrases as "A or B", "at least one of A and B", "at least one of A or B", "A, B, or C", "at least one of A, B, and C", and "at least one of A, B, or C", may include any one of, or all possible combinations of the items enumerated together in a corresponding one of the phrases.

It is to be understood that if an element (e.g., a first element) is referred to, with or without the term "operatively" or "communicatively", as "coupled with", "coupled to", "connected with", or "connected to" another element (e.g., a second element), it means that the element may be coupled with the other element directly (e.g., wiredly), wirelessly, or via a third element.

In concluding the detailed description, those skilled in the art will appreciate that many variations and modifications can be made to the preferred embodiments without substantially departing from the scope of the invention as defined by the claims.

## Claims

1. A display device comprising:
a substrate;
a light emitting element layer (EML) disposed on the substrate, the light emitting element layer comprising a plurality of light emitting elements configured to emit light;
a light control layer (LCL) disposed on the light emitting element layer, the light control layer comprising a light-transmitting layer (LT) configured to transmit the light and a light-blocking layer (LS) configured to block the light;
an intermediate layer comprising at least one of a thin film encapsulation layer (TFEL) or a touch sensor layer (TSU), wherein the intermediate layer is disposed between the light emitting element layer (EML) and the light control layer (LCL); and
a groove (GRV) passing through at least a portion of the intermediate layer,
wherein at least a portion of the light-blocking layer (LS) is disposed in the groove.

2. The display device of claim 1, wherein the width of the groove is greater than the width of the light-blocking layer.

3. The display device of claim 2, wherein at least a portion of the light-transmitting layer is disposed in the groove.

4. The display device of claim 3, wherein the light-transmitting layer is disposed between a side of the groove and a side of the light-blocking layer in the groove.

5. The display device of claim 4, wherein the side of the groove and the side of the light-blocking layer are not in direct contact with each other in the groove.

6. The display device of any one of the preceding claims, wherein:
the touch sensor layer comprises at least one touch electrode, and
the groove does not overlap the touch electrode.

7. The display device of claim 1, wherein the width of the groove is equal to the width of the light-blocking layer.

8. The display device of claim 7, wherein a side of the groove and a side of the light-blocking layer are in direct contact with each other in the groove.

9. The display device of claim 8, wherein the light-transmitting layer is not disposed in the groove.

10. The display device of any one of the preceding claims, further comprising a capping layer disposed between the groove and the light control layer.

11. The display device of claim 10, wherein the capping layer covers a side and a bottom surface of the groove.

12. The display device of any one of the preceding claims, further comprising an overcoat layer disposed on the light control layer.

13. The display device of any one of the preceding claims, wherein a bottom surface of the groove overlaps the thin film encapsulation layer.

14. The display device of any one of the preceding claims, wherein a bottom surface of the groove overlaps the touch sensor layer.

15. A method for manufacturing a display device according to any one of the preceding claims, the method comprising:
preparing a display panel, the display panel comprising:
a substrate,
a light emitting element layer disposed on the substrate, the light emitting element layer comprising a plurality of light emitting elements configured to emit light, and
an intermediate layer disposed on the light emitting element layer, the intermediate layer comprising at least one of a thin film encapsulation layer or a touch sensor layer; and
either:
forming a groove passing through at least a portion of the intermediate layer; and
forming a plurality of light-transmitting portions in the groove;
or:
forming a light-transmitting material layer on the intermediate layer; and
forming a plurality of light-transmitting portions by forming a groove passing through at least a portion of the intermediate layer and the light-transmitting material layer;
the method further comprising:
forming a light-blocking layer in the groove by depositing a light-blocking material between adjacent ones of the light-transmitting portions.
